(19) Europäisches Patentamt
European Patent Office
Office européen des brevets

(11) **EP 2 577 327 B1**

(12) **EUROPEAN PATENT SPECIFICATION**

(45) Date of publication and mention
of the grant of the patent:
**19.03.2014 Bulletin 2014/12**

(51) Int Cl.:
***G01R 15/24*** *(2006.01)*

(21) Application number: **11712575.7**

(22) Date of filing: **07.04.2011**

(86) International application number:
**PCT/EP2011/055408**

(87) International publication number:
**WO 2011/154174 (15.12.2011 Gazette 2011/50)**

(54) **HIGH-VOLTAGE SENSOR WITH AXIALLY OVERLAPPING ELECTRODES AND LOCAL FIELD SENSORS**

HOCHSPANNUNGSSENSOR MIT AXIAL ÜBERLAPPENDEN ELEKTRODEN UND LOKALEN FELDSENSOREN

CAPTEUR DE HAUTE TENSION AVEC ÉLECTRODES SE CHEVAUCHANT AXIALEMENT ET CAPTEURS DE CHAMP LOCAUX

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.06.2010 PCT/EP2010/057872**

(43) Date of publication of application:
**10.04.2013 Bulletin 2013/15**

(73) Proprietor: **ABB Research Ltd.**
**8050 Zürich (CH)**

(72) Inventors:
• **ERIKSSON, Göran**
**S-723 35 Västeras (SE)**
• **BOHNERT, Klaus**
**CH-5452 Oberrohrdorf (CH)**
• **MARCHESE, Sergio, Vincenzo**
**CH-8050 Zürich (CH)**
• **WILDERMUTH, Stephan**
**CH-5243 Mülligen (CH)**

(74) Representative: **ABB Patent Attorneys**
**C/o ABB Schweiz AG**
**Intellectual Property (CH-LI/IP)**
**Brown Boveri Strasse 6**
**5400 Baden (CH)**

(56) References cited:
**EP-A1- 2 138 853**      **WO-A1-2008/077255**
**CH-A- 547 496**      **US-A- 3 462 545**

• **BOHNERT K ET AL: "Optical fiber sensors for the electric power industry", OPTICS AND LASERS IN ENGINEERING, ELSEVIER, vol. 43, no. 3-5, 1 March 2005 (2005-03-01), pages 511-526, XP004629266, ISSN: 0143-8166, DOI: 10.1016/J.OPTLASENG.2004.02.008**

**Description**

Technical Field

The invention relates to a voltage sensor for measuring a voltage between a first and a second contact point, in particular to a voltage sensor with a an insulator, such as a body of an insulating material, extending between the contact points and with electrodes arranged in said body. The invention also relates to an assembly of several such voltage sensors arranged in series.

Background Art

Optical high-voltage sensors often rely on the electro-optic effect (Pockels effect) in crystalline materials such as $Bi_4Ge_3O_{12}$ (BGO) [1]. An applied voltage introduces a differential optical phase shift between two orthogonal linearly polarized light waves propagating through the crystal. This phase shift is proportional to the voltage. At the end of the crystal the light waves commonly interfere at a polarizer. The resulting light intensity serves as a measure for the phase shift and thus the voltage.

US 4,904,931 [2] and US 5,715,058 [3] disclose a sensor where the full line voltage (up to several 100 kV) is applied over the length of a single BGO crystal [1]. A method used to retrieve the applied voltage from the resulting modulation pattern is described in [4]. An advantage is that the sensor signal corresponds to the true voltage (i.e. the line integral of the electric field along the crystal). However, the electric field strengths at the crystal are very high. In order to obtain sufficient dielectric strength, the crystal is mounted in a hollow high-voltage insulator made of fiber-reinforced epoxy filled with $SF_6$-gas under pressure for electric insulation. The insulator diameter is sufficiently large to keep the field strength in the air outside the insulator below critical limits.

In EP 0 316 635 [5], a sensor is described where the applied voltage is approximated by multiple local electric field measurements using piezo-electric sensing elements such as the ones described in more detail in EP 0 316 619 [6]. With proper choice and orientation of the piezo-electric crystals only one component of the electric field is measured and thus the sensitivity to external field perturbations is reduced. A similar concept has been described in US 6,140,810 [7]. Here however the individual piezo-electric sensing elements are equipped with field steering electrodes and connected with electric conductors such that full integration of the electric field is performed. Dividing the voltage among several crystals reduces the peak electric fields such that a slim insulator is sufficient to provide the required dielectric strength.

US 6,252,388 [8] and US 6,380,725 [9] further describe a voltage sensor which uses several small electro-optical crystals mounted at selected positions along the longitudinal axis of a hollow high-voltage insulator. The crystals measure the electric fields at their locations. The sum of these local field measurements serves as an approximation of the voltage applied to the insulator. Here, the field strengths at a given voltage are significantly lower than with the design of [2] and insulation with nitrogen at atmospheric pressure is sufficient. However, since the sensor does not measure the line integral of the field but derives the signal from the field strengths at a few selected points between ground and high voltage, extra measures (permittivity-shielding or resistive shielding) to stabilize the electric field distribution are necessary to avoid excessive approximation errors [9].

A drawback of the above concepts is the requirement of an expensive high-voltage insulator of large size. The outer dimensions are similar to the ones of corresponding conventional inductive voltage transformers or capacitive voltage dividers. Thus, the attractiveness of such optical sensors is limited.

Refs. [10] and [11] describe an electro-optical voltage sensor of the type as in [2, 3], but with an electro-optic crystal embedded in silicone. A hollow high-voltage insulator of large size and $SF_6$-gas insulation is thus avoided. As in [7] the voltage may be partitioned on several crystals.

When only a fraction of the total voltage is measured, more compact integrated sensor arrangements can be used, see e.g. US 5,029,273 [12].

Various techniques used to extract the electro-optic phase modulation from the measured signals are known: As described above, the technique used in [4] relies on the applied voltage exceeding the half-wave voltage of the electro-optic crystal. Moreover, a signal at quadrature or some other means to achieve a non-ambiguous output is required. An advantage of this technique is that the light can be guided from the light source to the sensor crystal using standard single-mode (SM) or multimode (MM) fibers - i.e. no polarization-maintaining (PM) fibers are needed. The polarizers required to obtain the linear polarization for the measurement can be incorporated into the sensing element. Likewise, the return fiber to the detector can be a non-PM fiber.

For voltages much lower than the crystals half-wave voltage another polarimetric technique is published in [13]. This technique is particularly suitable for measurements using local field sensors. These sensors only measure a fraction of the total line voltage much smaller than the voltages measured with full integration.

A technique for the retrieval of the electro-optic phase shifts based on non-reciprocal phase modulation is known from fiber-optic gyroscopes [14] and has also been described for fiber-optic current sensors [15]. It has been adapted for use with piezo-electric and electro-optic voltage sensors [16, 17]. It is particularly suitable for small phase shifts, but in general requires the use of PM fibers for the link between an optical phase modulator - typically located near the light source and detector - and the sensing element positioned in the high voltage insulator.

Another concept is known from high-voltage bushings. There is often a need in high-voltage systems to pass high-voltage conductors through or near by other conductive parts that are at ground potential (e.g. at power transformers). For this purpose the high-voltage conductor is contained within a feed-through insulator. The insulator contains several layers of metal foil concentric with the high-voltage conductor and insulated from each other. By appropriately choosing the length of the individual cylinders of metal foils, the distribution of the electric field within and near the bushing can be controlled in such a way that a relatively homogeneous voltage drop from high-voltage to ground potential occurs along the outer surface of the bushing [18, 19].

CH 547496 A discloses high voltage insulators that are equipped with staggered electrodes and have optical fibres arranged between and around the electrodes and EP 2138853 A1 discloses an optical voltage transformer equipped with an electro-optic element arranged in a cavity, on its inner cavity surface a ground layer is provided. Furthermore, US 3462545 A discloses a high voltage condenser bushing having concentric metallic cylindrical foils separated by layers of insulating material.

Disclosure of the Invention

The problem to be solved by the present invention is to provide a voltage sensor for measuring a voltage between a first and a second contact point of alternative design.

This problem is solved by the voltage sensor of claim 1. Accordingly, the voltage sensor comprises an insulator. The insulator is elongate and extends along an axial direction between the first and the second contact points. An electric field sensor is arranged within a sensing cavity inside the insulator. Typically, the length of the sensing cavity is significantly shorter than the length of the insulator. Further, a plurality of conductive electrodes is arranged in the insulator. The electrodes are mutually separated by the insulating material and capacitively coupled to each other. At least a subset of the electrodes (or the whole set of the electrodes) is arranged such that each electrode of the subset axially overlaps at least another one of the electrodes from the subset.

The electrodes allow to control the surfaces of electric equipotential such that on the outer surface of the insulator the voltage drops over the full length of the insulator while inside the insulator the voltage drops over the (shorter) length of the sensing cavity. Advantageously the voltage drops essentially homogeneously both along the outer surface of the insulator and over the length of the sensing cavity.

Whereas in the absence of the voltage sensor the normal to the surfaces of equipotential is essentially parallel to the axial direction, the normal is perpendicular to the axial direction in the vicinity of the electrodes if such electrodes are present.

The electrodes allow to concentrate the electric field within the sensing cavity with a field strength larger than the (average) field strength at the outside of the voltage sensor, i.e. larger than the voltage between the contact points divided by the distance between the contact points.

At least one electric field sensor is a local electric field sensor in the sense that it measured the field over only part of an axial extension of the cavity. This design obviates the need to use a large field sensor.

Advantageously, the at least one field sensor is an optical field sensor introducing a field-dependent phase shift $\varphi\Delta$ between

-  a first sensor polarization or sensor mode and
-  a second sensor polarization or sensor mode of light passing through it. Such an optical field sensor can e.g. be an electro-optical device with field-dependent birefringence, in particular a crystal (e.g. BGO or BSO) or a section of a poled waveguide. The optical field sensor can, however, also be a piezo-electric device, in particular of crystalline quartz or a piezoelectric ceramic and a waveguide carrying at least two modes, with the waveguide being connected to the piezoelectric device such that the length of the waveguide is field-dependent.

Advantageously, at least one of the electrodes is a shield electrode radially surrounding said sensing cavity. The shield electrode can be capacitively coupled to two subsets of electrodes and it prevents the high electric field within the sensing cavity from extending into the air outside the sensor.

Advantageously, the voltage sensor comprises two sets of mutually staggered electrodes.

The invention in its advantageous embodiments provides a high-voltage sensor with a slender and lightweight insulator of low cost. The electrodes provide electric field steering. A solid-state insulation may suffice (no oil or gas).

The invention also relates to an assembly of such high-voltage sensors in series. A combination of several modules of the same high-voltage sensor can be used for measuring a large range of different voltage levels.

Other advantageous embodiments are listed in the dependent claims as well as in the description below.

Brief Description of the Drawings

The invention will be better understood and objects other than those set forth above will become apparent from the following detailed description thereof. Such description makes reference to the annexed drawings, wherein:

Fig. 1 is a sectional view of a voltage sensor,
Fig. 2 shows the calculated equipotential lines inside the measurement cavity (the field steering electrodes are omitted),
Fig. 3 shows the relative field strength along the axial direction inside the measurement for three different boundary conditions,
Fig. 4 shows (a) a single voltage sensor as well as assemblies of two (b) and four (c) voltage sensors,
Fig. 5 shows a sensing assembly for a collimated beam in a bulk crystal without quarter-wave plate,
Fig. 6 shows a sensing assembly for a collimated beam in a bulk crystal with quarter-wave plate,
Fig. 7 shows the measured intensity as a function of applied voltage for the sensing assemblies of Figs. 5 and 6,
Fig. 8 shows a sensing assembly with beam splitter,
Fig. 9 shows an assembly with polarization maintaining fiber to allow separating the beam splitter and polarizers from the electro-optic crystal,
Fig. 10 shows a waveguide optical sensor with two polarizers (a) or one polarizer (b),
Fig. 11 shows a configuration for detection using nonreciprocal phase modulation with a single optical field sensor,
Fig. 12 shows a configuration using nonreciprocal phase modulation with a single optical field sensor incorporating a 90° rotation of the PM fiber axes,
Fig. 13 shows configurations for nonreciprocal phase modulation detection using multiple crystals: (a) sensing elements positioned in the same fiber segment, (b) crystals positioned in two different fiber segments with fibers rotated by 90°, (c) crystals positioned in two different fiber segments and oriented anti-parallel with respect to each other, (d) reflective coating or mirror directly added to crystal end instead of fiber end,
Fig. 14 shows a configuration for nonreciprocal phase modulation detection using multiple electro-optic (EO) crystals in a modular configuration,
Fig. 15 shows a configuration with parallel arrangement of sensing elements resulting in three parallel measurement channels, where channels can share a common light source and signal processor,
Fig. 16 shows a configuration with vibration compensation, where the orientation of the electro-optic axes of the crystals is depicted by the letter z and the numbers 1 and 2, the two orthogonal polarizations are shown by the solid and dashed arrows,
Fig. 17 shows a field sensor on a dielectric substrate.

Modes for Carrying Out the Invention

*Definitions*

The term "high voltage" designates voltages exceeding 10 kV, in particular exceeding 100 kV.
The terms "radial" and "axial" are understood in respect to the axial direction (along axis 8, z-axis) of the sensor, with radial designating a direction perpendicular to the axial direction and axial designating a direction parallel to the axial direction.
A given electrode "axially overlapping" another electrode indicates that there is a range of axial coordinates (z-coordinates) that the two electrodes have in common.

*Voltage sensor with electric field steering*

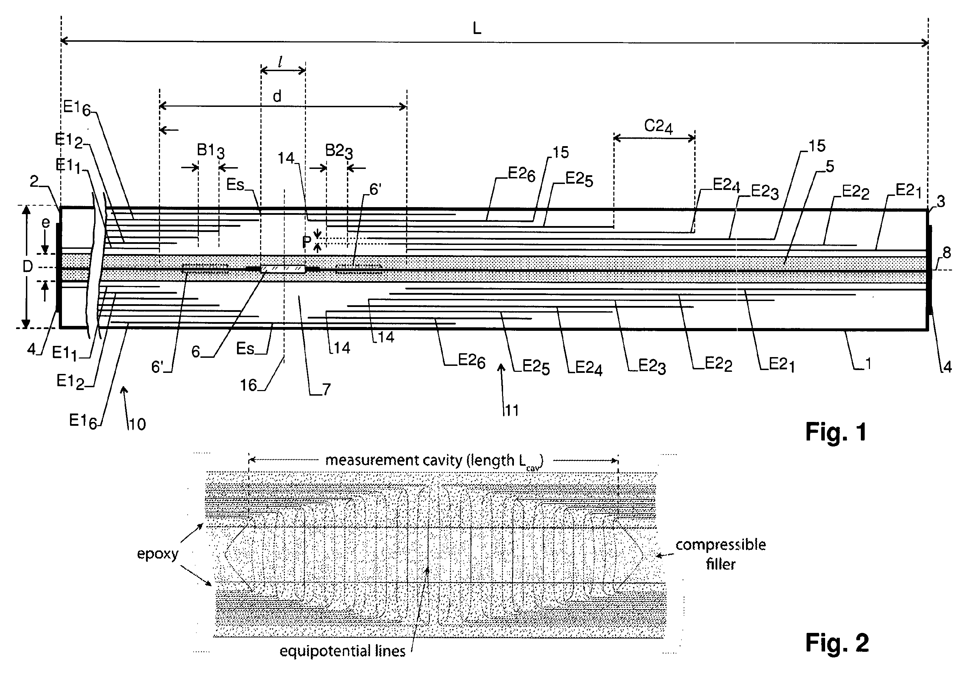

Fig. 1 shows an embodiment of a voltage sensor. Instead of using a permittivity shielding [8] or resistive shielding [9], the present embodiment comprises an elongated, advantageously rod-shaped body with a hollow core, which body is of an insulating material forming an insulator 1, such as epoxy resin or paper impregnated with epoxy resin. It extends between a first contact point 2 and a second contact point 3, both of which may be equipped with metal contacts 4 for contacting neighboring voltage sensors or voltage potentials. In the present embodiment insulator 1 is cylindrical. It has a central bore 5 filled with a filler material.
At least one electric field sensor 6, in the present embodiment an optical field sensor, such as a cylinder-shaped crystal of $Bi_4Ge_3O_{12}$ (BGO) or $Bi_4Si_3O_{12}$ (BSO), is placed inside bore 5 within a sensing cavity 7. Sensing cavity 7 is advantageously at a center between first contact point 2 and second contact point 3 in order to minimize the distortion of the electrical field around the voltage sensor.
A reference plane 16 perpendicular to axis 8 of the device and arranged at the center of sensing cavity 7 is used in the following as geometric reference for describing the geometry of some of the electrodes. Note: Here it is assumed that sensing cavity 7 is located in the middle between contact points 2 and 3. Asymmetric positions of sensing cavity 7 will be briefly considered further below. Further, it is noted that the term "cavity" does not imply that there is an absence of insulating material in the respective region.

A plurality of electrodes E is arranged in insulator 1. The electrodes E are mutually separated by the insulating material of insulator 1 and capacitively coupled to each other. In the present embodiment, the electrodes E are formed by a metallic spiral (consisting e.g. of thin aluminum foil) forming shells of different axial extension concentric to longitudinal axis 8. The electrodes E control the surfaces of equipotential and the distribution of the electric field outside and inside insulator 1. The lengths (i.e. axial extensions) of the individual electrodes E and their radial and axial positions are chosen such that the surfaces of equipotential are spaced essentially equidistantly along the full length of the outer surface of insulator 1 and are concentrated, but again with essentially equal distances, in sensing cavity 7. As a result the applied voltage V drops uniformly along the outer rod surface as well as along the sensing cavity. Advantageously, the axial length $l$ of the field sensor is much smaller, e.g. at least 5 times smaller, than the axial length d of the cavity. Typically, the length of sensing cavity 7 is in the range of 100 - 250 mm. The volume of central bore 5 outside cavity 7 is essentially field-free.

At least one of the electrodes E is a shield electrode $E_S$ and radially surrounds sensing cavity 7, thereby capacitively coupling the two sets of electrodes that are separated by reference plane (16).

One electrode, designated $E1_1$, is electrically connected to first contact point 2, and subsequently called the "first primary electrode". Another electrode, designated $E2_1$, is electrically connected to second contact point 3, and subsequently called the "second primary electrode". These two electrodes carry the potential of the contact points 2 and 3, respectively. The other electrodes are on floating potential and form a capacitive voltage divider between the two primary electrodes and therefore are at intermediate potentials.

In addition to shield electrode $E_S$, the electrodes comprise a first set of electrodes, named $E1_i$ with i = 1 .. N1, and a second set of electrodes, named $E2_i$ with i = 1 .. N2. For symmetry reasons, N1 advantageously equals N2. In the embodiment of Fig. 1, N1 = N2 = 6, but the actual number of electrodes may vary.

The electrodes $E1_i$ of the first set are arranged in a first region 10 of insulator 1, which extends from the center of sensing cavity 7 to first contact point 2, while the electrodes $E2_i$ of the second set are arranged in a second region 11 of insulator 1, which extends from the center of sensing cavity 7 to second contact point 3.

Electrode $E1_1$ of the first set of electrodes forms the first primary electrode and electrode $E2_1$ of the second set forms the second primary electrode. These electrodes are radially closest to longitudinal axis 8, with the other electrodes being arranged at larger distances from longitudinal axis 8.

As mentioned above, the various electrodes overlap in axial direction and are of a generally "staggered" design. Advantageously, one or more of the following characteristics are used:

a) For each set j (j = 1 or 2) of electrodes, the electrodes $Ej_i$ and $Ej_{i+1}$ axially overlap along an "overlapping section". In this overlapping section the electrode $Ej_{i+1}$ is arranged radially outside from the electrode $Ej_i$.
b) For each set j of electrodes:

- Each electrode has a center end (as illustrated by reference number 14 for some of the electrodes in Fig. 1) facing reference plane 16 of the sensor and a contact end (as illustrated by reference number 15) axially opposite to center end 14,
- Center end 14 of electrode $Ej_{i+1}$ is closer to reference plane 16 than center end 14 of the electrode $Ej_i$ and contact end 15 of electrode $Ej_{i+1}$ is closer to reference plane 16 than contact end 15 of the electrode $Ej_i$, hence electrode $Ej_{i+1}$ is shifted towards the center as compared to electrode $Ej_i$.
- Contact end 15 of the electrode $Ej_{i+1}$ has an axial distance $Cj_i$ from contact end 15 of the electrode $Ej_i$, and center end 14 of electrode $Ej_{i+1}$ has an axial distance $Bj_i$ from center end 14 of electrode $Ej_i$, and
- The electrodes $Ej_i$ and $Ej_{i+1}$ axially overlap between contact end 15 of electrode $Ej_{i+1}$ and center end 14 of electrode $Ej_i$.

c) The distances $Bj_i$ and $Cj_i$ can be optimized according to the desired field design. In particular, for obtaining a stronger field within sensing cavity 7 than outside the voltage sensor, the axial distance $Bj_i$ is advantageously chosen to be smaller than the corresponding axial distance $Cj_i$, for all i and j.
d) For most designs, if a homogeneous field is desired in sensing cavity 7, the axial distances $Bj_i$ should be substantially equal to a common distance B, i.e. they should all be the same. Similarly, if a homogeneous field is desired at the surface and outside the voltage sensor, the axial distances $Cj_i$ are advantageously substantially equal to a common distance C, i.e. they are also all the same.
e) Shield electrode $E_S$ should advantageously have an axial overlap with at least one electrode of the first set and also with at least one electrode of the second set. This, on the one hand, provides improved protection against the high electrical fields in sensing cavity 7 reaching the surface of the device. On the other hand, it provides good capacitive coupling between the two sets of electrodes via the shield electrode, thereby decreasing the corresponding voltage drop. To further improve this capacitive coupling as well as the field homogeneity within sensing cavity 7, shield electrode Es advantageously has an axial overlap with the radially outmost electrode $E1_6$ of the first set and the radially outmost electrode $E2_6$ of the second side and is arranged radially outside from these outmost electrodes $E1_6$ and $E2_6$.

f) In order to evenly distribute the fields outside and inside the voltage sensor, the electrodes are advantageously arranged symmetrically in respect to reference plane 16 of the device.

g) For the same reason, the electrodes are advantageously cylindrical and/or coaxial to each other, in particular coaxial with the longitudinal axis 8.

Fig. 1 further illustrates some other advantageous aspects:

- Field sensor 6 (which is e.g. an electro-optical crystal) is advantageously cylindrical with a length $l$ and is positioned in central bore 5 (diameter e) of insulator 1 (outer diameter D and length L), and within sensing cavity 7.
- Insulator 1 contains, as an example, six electrodes in both the first and the second set. These electrodes $Ej_i$, as well as shield electrode Es, are advantageously of a metal foil, concentric with field sensor 6 and insulator 1.
- With $Bj_i$ and $Cj_i$ chosen as described above, advantageously, the electrodes of the two sets are equally spaced in radial direction with a uniform separation distance P between neighboring electrodes, and also the radial distance between the outmost electrode $E1_6$, $E2_6$ of each set and shield electrode $E_S$ is equal to P. Again, this contributes to distribute the electrical fields more evenly both inside and outside insulator 1.
- Advantageously, shield electrode $E_S$ is positioned at mid-distance between the contact ends 2, 3.
- The primary electrodes $E1_1$ and $E2_1$ are in contact with the two electric potentials, e.g. ground and high-voltage potentials, at the corresponding contact points 2, 3 by means of the metal contacts 4.
- Advantageously, insulator 1 is equipped with sheds, consisting e.g. of silicone, on its outer surface (not shown in Fig. 1), which provide increased creep distance between high-voltage and ground potential for outdoor operation.

The field steering by the electrodes $Ej_i$ and $E_S$ avoids excessive local peak fields both outside and inside insulator 1. As a result the radial dimensions of insulator 1 can be relatively small without the danger of electric breakdown in the environmental air.

In an advantageous configuration, the bore is filled with a solid but compressible filler material that provides sufficient dielectric strength and good adhesion to the epoxy surface as well as to the local field sensors. Good materials are polyurethane foam containing tiny gas bubbles (e.g. N2 or SF6 gas) and silicone containing expandable thermoplastic micro-spheres. When filling the bore at room temperature, the filler material may have to be inserted with a slight overpressure to assure the shrinkage of the filler at low temperatures does not cause detachment from the insulator walls which could lead to flashovers inside the bore. As mentioned, the filler material may additionally serve to fix the position of field sensor 6 and provide damping of mechanical shock and vibration. In an alternative configuration, a liquid (e.g. transformer oil) or gas (e.g. N2, SF6) can be used or the remaining volume can be evacuated.

Due to its light weight the voltage sensor may be suspension-mounted in a high-voltage substation.

The dimensions of the voltage sensor and its parts depend on the rated voltage and are chosen such that the sensor meets the requirements of relevant standards for over-voltages, lightning and switching impulse voltages. For example, insulator 1 of a 125 kV-module may be an epoxy rod having an overall length of about 1 to 1.5 m and a diameter of 50 to 80 mm. The inner bore 5 of the rod may then have a diameter between 15 and 25 mm. The parameters a, $B_{ij}$, $C_{ij}$, D, P are chosen such that the voltage applied to the rod ends drops as uniformly as possible over the length of the crystal within the bore and the full length of the epoxy rod at its outer surface. The design may be optimized by using an adequate numerical electric-field simulation tool.

Choosing the distances $B_{ij}$ as well as $C_{ij}$ to be equal as described above also contributes to simple and cost efficient insulator fabrication.

Besides facilitating the full integration of the electric field, the capacitive field steering described here represents a very efficient way of shielding the internal field geometry from outside perturbations. Advantageously, the insulator capacitance is significantly larger than environmental stray capacitances to maximize the shielding effect. The design thus enables relatively precise measurement of the applied voltage with local electric field sensors. This leads to a cost effective solution due to the reduced size of the local electric field sensors. Moreover, the use of integrated-optic waveguide sensors becomes possible.

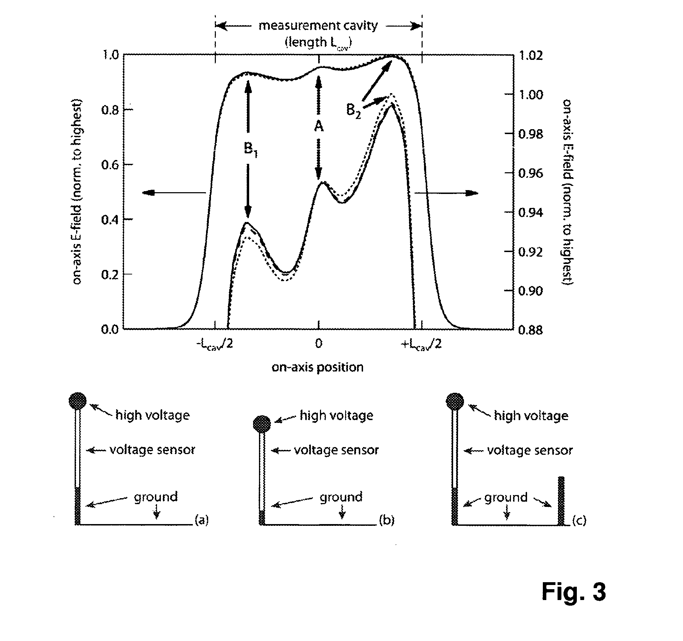

Numerical field calculations reveal that the voltage drop inside the cavity 7 is relatively homogeneous, see Figs. 2 and 3. Fig. 3 shows the calculated relative field strength along the insulator axis inside the measurement cavity with length $d = L_{cav}$. The zero position denotes the center of the cavity 7. The three curves correspond to three different boundary conditions shown below: (a) voltage sensor on long grounded post (solid curve), (b) on short grounded post (dotted curve), (c) on long grounded post with grounded construction in vicinity (dashed curve). The letter A depicts a location where the electric field is particularly stable. The measurement of a local field sensor at this position will show a very low sensitivity to the external perturbations mentioned above. A local field sensor is advantageously placed at such a position. Hence, if cavity 7 is symmetric to reference plane 16, at least one field sensor is advantageously arranged symmetrically to reference plane 16 and is intersected by the same, i.e. it is located at point A.

Alternatively or in addition thereto, multiple local field sensors, in particular two local field sensors, can be positioned at different locations inside the measurement cavity such that, when adding the measured fields, the effects of external perturbations cancel each other (e.g. points B1 and B2 in Fig. 3). Suitable locations and their stability with respect to external perturbations may depend on the boundary conditions and their variation during operation of the voltage sensor and must thus be analyzed for a particular application.

For example, if cavity 7 is symmetric to reference plane 16, a plurality of the field sensors 6 is advantageously arranged symmetrically in respect to said reference plane, such as shown for the field sensors 6' depicted in dotted lines in Fig. 1.

In more general terms, the position of the at least one field sensor 6 is symmetrical to reference plane 16. This statement indicates that if there is a single field sensor 6, the position of the field sensor coincides with reference plane 16. If there are several field sensors 6, their positions are symmetric to reference plane 16, i.e. the positions are invariant under a mirroring operation in reference plane 16.

Fig. 1 illustrates but one possible design of the electrodes. It must be noted that, depending on the required size and shape of the sensor, the design of the electrodes may vary.

For example, the electrodes may also be non-cylindrical, e.g. by having an oval cross section or by having varying diameter. The electrodes may e.g. be frusto-conical, their end sections 15 may be flared outwards or their end-sections 14 may be flared inwards.

Each electrode can consist of a continuous conductive sheet, such as a metal foil, or it may e.g. be perforated or have gaps.

*Assembly of several voltage sensors*

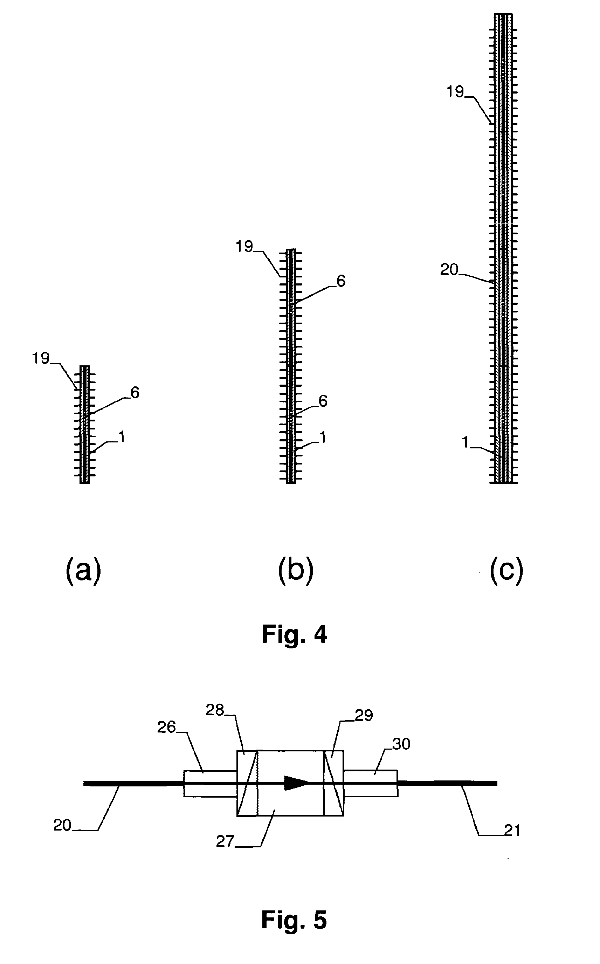

The voltage sensor described above may form a module in an assembly of several voltage sensors arranged in series. One such module is shown in Fig. 4a. In particular, a module containing a single field sensor 6 as described above may be designed for a rated voltage of e.g. 125 kV or 240 kV. Fig. 4a also shows schematically the sheds 19 applied to the outside of insulator 1.

For operation at 240 kV, two 125 kV modules may be mounted in series (Fig 4b). The primary electrodes $E2_1$ and $E1_2$ of the neighboring modules are in electric contact at the joint between the two modules. The voltage is then about evenly partitioned on the two field sensors 6 (Note: In practice the voltage ratio will be affected to some degree by environmental stray capacitances). Alternatively, a single continuous insulator (with a length of about twice the length of the individual rods) which contains two field sensors 6 and two corresponding assemblies of field steering electrodes may be used instead of two separate epoxy rods.

Fig. 4c shows an assembly of four modules.

It should be noted that distributing the voltage on two or more separate crystals of length 1 results in a smaller insulator diameter and thus lower insulator cost than applying the same voltage to a single crystal of length 21.

*Field sensor assembly*

In the embodiment of Fig. 1, the field sensor 6 is substantially suspended by the filler material in bore 5.

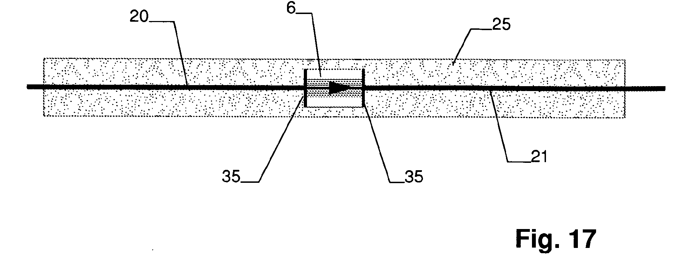

Alternatively, field sensor 6 may be attached to a dielectric substrate or be embedded into such a substrate, i.e. the high-voltage sensor comprises a dielectric substrate arranged in cavity 7 and holding field sensor 6. In, particular, and as shown in Fig. 17, a suitable substrate 25 may have the shape of a beam with e.g. cylindrical or square cross section extending axially through the cavity 7 to substrate mounts in the field-free zones of the insulator bore 5. The substrate may be made e.g. from fused silica or from the same material as the sensing element itself or from a combination of several materials. The substrate may also extend through the whole insulator bore 5 to mounts at the two insulator ends. Furthermore, the fibers 20, 21 to and from the sensing element may be embedded into the substrate 25 in a way that the sensing element, the fibers, and the substrate form an integral device which can be inserted as a whole into insulator bore 5. Such a configuration can be designed to reduce steps in the dielectric constant at the boundaries between the ends of the local field sensors and the filler material.

Field sensor 6 is advantageously an embedded electro-optic crystal waveguide with a polarizing layer 35 at its input surface and a quarter wave retarder 24 and a polarizing layer 35 at its output surface in case of polarimetric detection (assuming the field sensor 6 is essentially free of birefringence). Alternatively, the polarizing layers are not required for detection using nonreciprocal phase modulation as described further below. Here polarization maintaining fibers to and from the crystal waveguide are used instead.

Advantageously, for minimizing field distortions, field sensor 6 has the same (average) permittivity as substrate 25.

*Local field measurement*

As the field distribution inside the sensing cavity is rather homogeneous and stable (see Fig. 3), a local (i.e. essentially point like) electric field measurement, for example at the center of cavity 7, can be used as described above. A local electric field sensor in this sense is a sensor that measures the electric field along only part of the axial extension of the cavity 7. The local field essentially varies in proportion to the applied voltage. The influence of thermal effects on the local field strength, e.g. due to the thermal expansion of sensing cavity 7, may be compensated in the signal processor and/or using the measures described below.

As a further alternative, also as mentioned, the voltage may be approximated from several local (point like) field measurements, with the local field sensors arranged at several points within cavity 7 along axis 8. Particularly, such an arrangement can be of advantage if the length of sensing cavity is chosen relatively long. Such an arrangement may also be of interest in case rather high voltages (e. g. 420 kV or higher) are to be measured with a single voltage sensor module.

Furthermore, a combination of several electro-optic crystals with inactive material (such as fused silica) in between as described in [10] and interrogated by a single light beam may be employed.

*Compensation of thermal effects*

The relation between the local field at the field sensor 6 and the voltage applied to the insulator needs to be known in order to determine the voltage. This relationship can be determined either by field calculations or by appropriate calibration of the sensor. The field geometry must be sufficiently stable such that this relationship does not change significantly under external influences such as electric field perturbations and temperature changes. A change in temperature, for example, alters the relative permittivities $\varepsilon_r(T)$ of the various materials and leads to a thermal expansion of the components. Typically, the length of the measurement cavity expands more strongly than does the electro-optic crystal, because the thermal expansion coefficient of the insulator material ($\sim 5 \cdot 10^{-5}$ /°C) is larger than that for typical electro-optic crystals (e.g. $6 \cdot 10^{-6}$ /°C for BGO). As a consequence, the fraction of the voltage seen by the crystal is reduced. This effect is partly compensated for certain advantageous crystals where the strength of the electro-optic effect increases with increasing temperature (e.g. $2.4 \cdot 10^{-4}$ /K for BGO [3]). With a suitable combination of used materials and sensor geometry the effects of temperature can be reduced or even compensated and sensor precision can thus be maintained over a large temperature range.

In general, the electric field distribution inside the sensing cavity, and in particular the distribution of the electrical field component in axial direction $E_z$, will vary with temperature as a consequence of the temperature dependence of the various coefficients of thermal expansion and of the relative permittivities. The mean axial electrical field component $E_{z,mean}$ in the local field sensor 6 becomes temperature-dependent as well, i.e. $\partial E_{z,mean}/\partial T \neq 0$. This temperature dependency which leads to a deviation of the measured voltage can be partly compensated by proper choice of local field sensor geometry and an electro-optic material where the temperature derivative of the electro-optic effect of the sensor has the opposite sign, resulting in a temperature-dependence of the field-dependent phase shift $\partial \Delta\varphi/\partial T$ close to zero.

*Optical sensor configurations for local field measurement*

The voltage applied to the insulator is measured by determining the electric field at one or multiple locations inside the measurement cavity 5 using local electric field sensors. An advantageous sensing technique used for the local electric field measurement is based on the electro-optic effect (Pockels effect). Two orthogonal polarizations experience a differential phase shift when propagating through an appropriately oriented electro-optic crystal in an electric field. The voltage applied to the crystal is then inferred from this phase shift. The light is guided from the source to the crystal and back to a detector by means of optical fibers.

In an advantageous configuration, a suitable electro-optic crystal is chosen and oriented such that only the axial component $E_z$ of the electric field is measured. If the light propagates axially through the crystal, this is the component of the electric field pointing in the propagation direction of the light. Such an electro-optic field sensor measures the voltage difference between the two crystal ends by integration of the projection of the electric field onto the optical path given by

$$V = \int_A^B E \cdot ds ,  \qquad (1)$$

where A an B are the points on the optical path where the light enters and exits the crystal, E is the electric field vector and ds is an infinitesimal path element vector along the optical path.

Ideally, the used crystal has no intrinsic birefringence or it is such that the axes of the intrinsic birefringence coincide with the principle electro-optic axis. In the latter case, the intrinsic birefringence simply adds to the induced birefringence and results in an additional phase offset of the orthogonal polarizations. Information on appropriate crystals and crystal classes can be found in [3]. Advantageous crystals for the present voltage sensor include bismuth germanate ($Bi_4Ge_3O_{12}$, BGO), bismuth silicon oxide ($Bi_4Si_3O_{12}$, BSO), and III-V-semiconductors, in particular gallium arsenide (GaAs). III-V-semiconductors are particularly advantageous because they have lower permittivity $\varepsilon$ than typical ferroelectric electro-optical crystals and therefore lead to lower field distortions within cavity 7.

GaAs modulators are of particular interest and may be adapted for use according to the present invention, in particular as a waveguide sensor. GaAs belongs to the same crystal class as BGO (class 43m) and is also suited to exclusively measure the longitudinal field component. Furthermore, the dielectric permittivity of GaAs ($\varepsilon = 12.9$) is relatively small so that a substantial fraction of the field penetrates into the crystal.

*Polarimetric detection*

A first sensor arrangement is shown in Fig. 5. The unpolarized light from a advantageously broadband source (not shown) is delivered via SM or MM fiber 20 and collimated using an appropriate collimating lens 26 at the fiber output. Before entering the electro-optic crystal 27, the light is linearly polarized, e.g. by a thin film polarizer 28, with the polarization oriented at 45° to the electro-optic axes of the crystal. Alternatives to a thin film polarizer include polarizing the light using an inline fiber polarizer.

At the end of the crystal 27, the phase shift induced by the applied electric field via electro-optic effect is probed by a polarizer 29 advantageously oriented at 0° or 90° relative to the first polarizer 28. It converts the phase modulation in the crystal 27 into an amplitude modulation, which can be measured with a photo diode. For this purpose the light is coupled back into an optical fiber 21 by a focusing lens 30 attached to the polarizer 29. For very short crystals sufficient light can be coupled back into the fiber 21 even without prior collimation and refocusing. In this case the lenses can be removed from the configuration shown in Fig. 5.

Assuming that the second polarizer oriented at 90° with respect to the first, the detected light intensity is given by

$$I(V) = I_0 \sin^2\left(\Delta\varphi(V)/2\right) = \frac{I_0}{2} \cdot \left(1 - \cos\left(\Delta\varphi(V)\right)\right), \qquad (2)$$

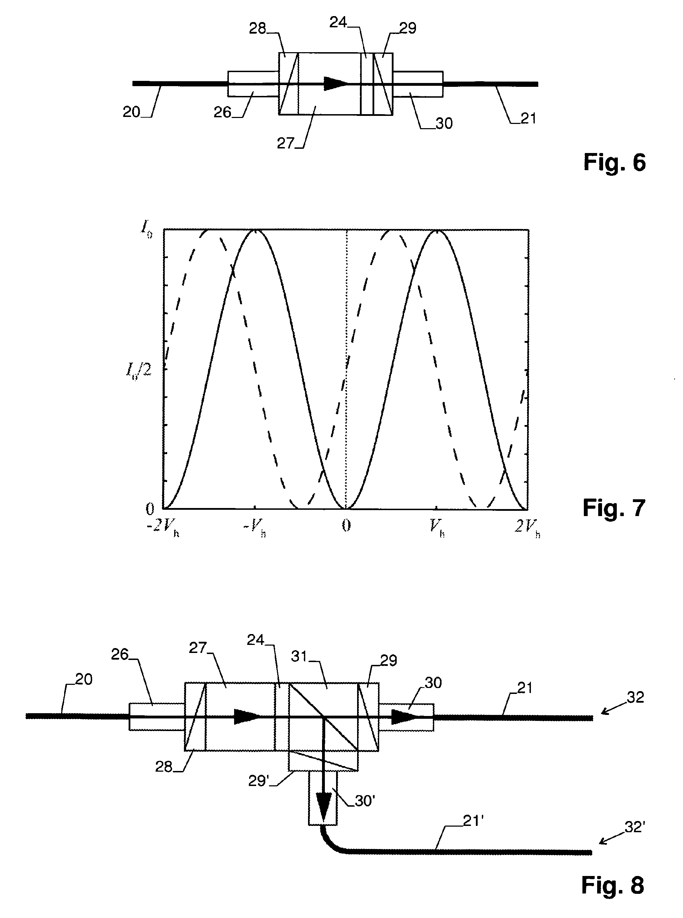

where $I_0$ is the intensity incident on the polarizer and V is the voltage applied to the crystal (see Fig. 7). The phase shift $\Delta\varphi$ between the two orthogonal polarizations is

$$\Delta\varphi(V) = \frac{\pi V}{V_h}, \qquad (3)$$

with $V_h$ being the half-wave voltage of the electro-optic crystal. At the half-wave voltage the phase shift between the two orthogonal polarizations is $\pi$ and the detected light intensity according to (2) reaches its maximum value $I_0$ (assuming no losses at the polarizer itself). Fig. 7 shows the measured intensity as function of the applied voltage of the embodiment of Fig. 5 (solid line).

Ideally, a quarter-wave plate is inserted between the crossed polarizers on either side of the crystal with its optical axis oriented along one of the electro-optic axis of the crystal, as shown in Fig. 6. The quarter-wave retarder 24 shifts the response curve by $\pi/2$, such that the detected intensity at zero voltage is in the linear regime of the sinusoidal modulation (see Fig. 7, dashed line). Equation (2) changes to

$$I(V) = \frac{I_0}{2} \cdot \left(1 - \cos\left(\Delta\varphi(V) + \frac{\pi}{2}\right)\right) = \frac{I_0}{2} \cdot \left(1 + \sin\left(\Delta\varphi(V)\right)\right) \quad (4)$$

Again, after the polarizer a focusing lens refocuses the beam into a single mode (SM) or multi mode (MM) fiber to guide the light to a detector.

According to equations (2) and (4), the measured intensity shows a sinusoidal oscillation as function of the applied voltage. The measured signal becomes ambiguous if the applied voltage exceeds the half-wave voltage. In this case the interrogation method described in [2-4] can be used to unambiguously extract the applied voltage from the measured intensity. The quadrature signal that is required for this interrogation technique can be generated by attaching a beam-splitter and a quarter-wave plate as well as a second detection fiber and detector to the end of the crystal, see Ref [3].

For a local field measurement, the length of the electro-optic crystal can range from less than a millimeter to several centimeters. The appropriate length depends on the applied voltage, the chosen material, and the desired interrogation technique. Since the optical field sensors used in this invention only perform a local field measurement, they normally see just a fraction of the total voltage applied to the insulator, and the crystal length is advantageously chosen such that the electro-optic phase shift is much smaller than $\pm \pi/2$. Using the configuration with quarter-wave plate 24 shown in Fig. 6, the measurement then takes place in the linear regime of the sinusoidal curve leading to a measured intensity approximated by

$$I(V) = \frac{I_0}{2} \left(1 + \Delta\varphi(V)\right). \quad (5)$$

Assuming the applied voltage is an ac voltage, the ac and dc components of the signal in (5) can be separated by means of appropriate low and high pass filters. The ratio of these two components yields the phase shift $\Delta\varphi(V)$ independent of the light intensity.

Alternatively, an interrogation according to [20] can be used: instead of directly attaching the polarizer to the quarter-wave plate 24 as shown in Fig. 6, the beam first is separated by a non-polarizing beam splitter element 31 into two output channels 32, 32' (see Fig. 8). At each output channel a polarizer 29, 29' is attached, such that they probe polarization directions at 90° with respect to each other. After the polarizers the beams are again focused into an SM or MM fiber 21, 21' by means of focusing lenses 30, 30' to be guided by fibers 21, 21' to two detectors. Instead of a non-polarizing beam splitter 31 with polarizers 29, 29' attached one can also use appropriately oriented polarization splitters which separate the beam into two perpendicularly polarized outputs. Examples are polarizing beam splitter cubes, Wollaston prisms, Nomarski prisms, Glan-Thompson prisms, Glan-Taylor prisms, Nicol prisms, etc.

Following from equation (4), the two output channels now measure

$$I_{1/2}(V) = \frac{I_0}{4} \cdot \left(1 \pm \sin\left(\Delta\varphi(V)\right)\right) \quad (6)$$

where the additional factor of 1/2 accounts for the beam splitter under the assumption that the splitting ratio is 50:50 and that losses are negligible. Dividing the difference of $I_1$ and $I_2$ by their sum results in a signal independent of the light intensity

$$\frac{I_1(V) - I_2(V)}{I_1(V) + I_2(V)} = \sin\left(\Delta\varphi(V)\right). \quad (7)$$

In an alternative configuration, the polarizer in one of the output channels (e.g. in channel 2) is omitted and one measures

$$I_2 = I_0/2 \quad (8)$$

independent of the applied voltage. The division of $I_1(V)$ from (6) and $I_2$ again yields a signal independent of the light intensity with which the phase shift and the voltage can be directly calculated.

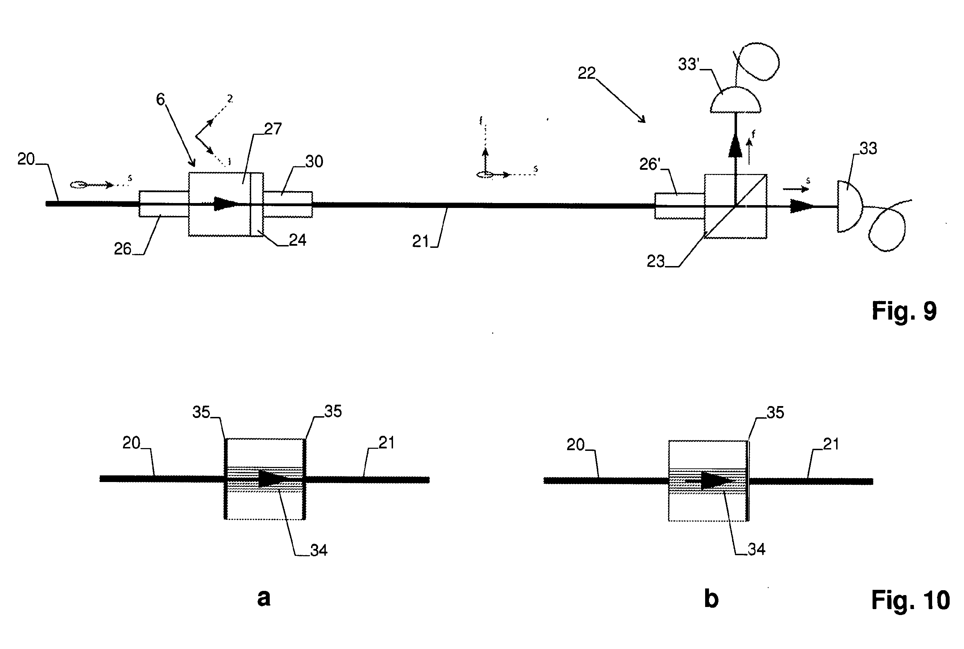

Yet another configuration involves the use of polarization maintaining (PM) fibers to allow separating the beam splitter and polarizers from the electro-optic crystal and thereby removing them from the measurement cavity 7. This configuration is shown in Fig. 9. Fig. 9 shows an optical assembly using e.g. a bulk crystal 27 and PM delivery fibers 20, 21. The electro-optic crystal 27 is located in the measurement cavity 7 of the isolator, whereas a detection unit 22 with a polarizing beam splitter 23 is located in the interrogation unit near the light source and electronics.

The light arrives at the crystal 27 polarized along either the fast (f) or slow (s) axis of PM delivery fiber 20. The PM fiber axes of fiber 20 are oriented at 45° to the crystal's electro-optic axes (1, 2) such that the polarization is separated into two orthogonal components. A quarter-wave plate 24 again shifts the working point into the linear regime of the response curve. The axes of the second PM delivery fiber 21 are also oriented at 45° to the crystal axes. With this arrangement the light intensities of the two orthogonal polarization modes of the fiber correspond to the two anti-phase superpositions of the orthogonal polarizations of the electro-optic crystal according to (6). The two signals may be separated at the end of PM delivery fiber 21 by feeding the light from delivery fiber 21 through a collimating lens 26' to a non-polarizing beam splitter and crossed polarizers that are aligned parallel to the fast and slow fiber axes, respectively. Alternatively - as shown in Fig. 9 - a polarizing beam splitter 23 may be used to omit the extra polarizers. The beams from the beam splitter are fed to a first and a second detector 33, 33', respectively.

In more general terms, the embodiment of Fig. 9 comprises an optical sensor introducing a voltage-dependent phase shift $\Delta\varphi(V)$ between a first sensor polarization or sensor mode and a second sensor polarization or sensor mode of light passing through it. The device further advantageously comprises a polarization maintaining fiber (i.e. fiber 21) connected to the optical sensor. This polarization maintaining fiber has at least a first polarization mode, i.e. it is able to carry light along at least a first polarization in polarization maintaining manner. The polarization maintaining fiber is connected to the optical sensor (i.e. to the crystal) in such a manner that

- light passing the optical sensor in said first sensor polarization or sensor mode as well as
- light passing said optical sensor in said second sensor polarization or sensor mode

are both partially coupled into the first polarization mode of the polarization maintaining fiber. The device further comprises a detector unit 22 connected to the polarization maintaining fiber. The detector unit comprises at least a first light detector (detector #1 or #2 of Fig. 9) measuring light passing through the first polarization mode of the polarization maintaining fiber.

Instead of propagating an unguided beam through the electro-optic crystal, the beam may be guided by an electro-optic crystal waveguide 34 embedded into the material [12] (see Figs. 10a and 10b), i.e. the optical sensor is formed by a waveguide. Preferably, the device implementation is similar to the one of integrated-optic phase modulators that have been developed for use in communication systems [21] and of sensors for mapping of electric field distributions [22]. In contrast to those applications, the waveguide structure for the present purpose is not equipped with electrodes to apply a voltage from an external source, but instead the structure is directly exposed to the electric field to be measured. Such an implementation is of particular interest as it eliminates the need of any focusing optics. Instead, the fibers may be directly pigtailed to the substrate containing the electro-optic waveguide. This simplifies the optical assembly and results in more compact devices. Furthermore, the simpler design also helps to reduce the risk of dielectric breakdown in high electric fields. Another important advantage is that several sensing elements at different locations can easily be linked by PM fibers. The total electro-optic phase shift can then be measured with a single interrogation system as described below.

In the embodiment of Figs. 10a and 10b polarizing layers 35 are arranged at least one of the entry and/or exit sides of waveguide 34.

An advantageous waveguide material is GaAs or other suitable compound semiconductors [9] for the reasons mentioned above.

In the configurations according to Fig. 6 and 9 the quarter-wave retarder 24 and/or polarizer 29 are sandwiched between the substrate of the optic field sensor and the corresponding lens. Instead of using such a discrete quarter-wave retarder, the waveguide itself may give rise to an intrinsic birefringent phase retardation corresponding to an odd multiple of a quarter-wave. Moreover, there are several options to introduce a proper amount of birefringence in case of materials which are free of natural birefringence (e.g. GaAs): (i) commonly a waveguide is not perfectly isotropic and therefore exhibits a certain degree of birefringence. By cleaving or polishing the waveguide to a proper length, the phase retardation may be adjusted to the desired value. (ii) An appropriate amount of birefringence may be introduced by irradiation of the waveguide with highly intense laser pulses [23]. The same procedures can be applied to materials with intrinsic birefringence in order to tune the working point of the sensor into the linear range of the response curve.

*Interrogation by nonreciprocal phase modulation*

Besides the polarimetric techniques described above, the technique of nonreciprocal phase modulation known from Sagnac interferometers, particularly from fiber gyroscopes [14], can be employed to interrogate the optical electric field sensors. This technique has also been used for fiber-optic current sensors and has been described in the context of optical high voltage sensors [17]. A particular advantage of this technique is that a single interrogation system can be used to measure the accumulated electro-optic phase shift of several sensing elements arranged in series.

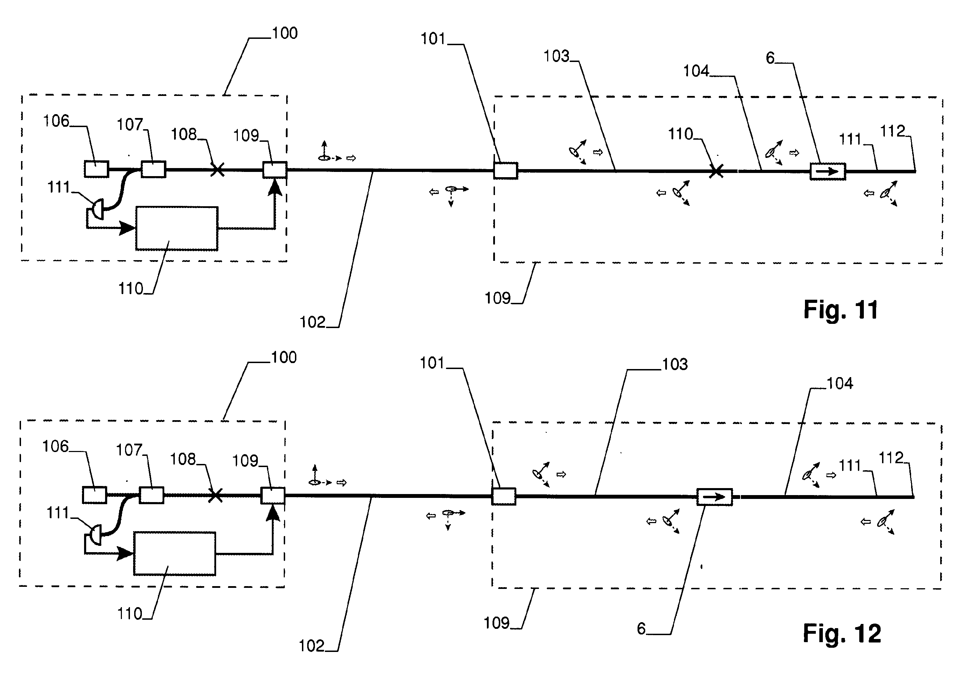

Sensor configurations of this type, as shown in Figs. 11 - 13, typically comprise:

- a control unit 100 adapted to determine the voltage to be measured from the phase shift $\Delta\varphi$ between light passing the optical sensor in the first sensor polarization or sensor mode and light passing the optical sensor in the second sensor polarization or sensor mode;
- a Faraday rotator 101 arranged between control unit 100 and optical sensor 6 and rotating the light passing through it by approximately 45° for each pass. Advantageously, a connecting PM fiber 102 is provided for connecting the control unit 100 with Faraday rotator 102.

As shown in Fig. 11, control unit 100 advantageously comprises a low-coherence light source 106 followed by a depolarizer (not shown) and an inline fiber polarizer 107. The following 45° splice 108 results in an equal distribution of the power into fast and slow axis of the subsequent PM fiber. An advantageously integrated-optic phase modulator 109, such as a lithium niobate (LN) modulator, serves to modulate the differential phase of the two orthogonal waves. The modulator is part of a closed-loop detection circuit which is used to recover the optical phase shift of the orthogonal light waves introduced by the electric field sensor of the sensor head [5]. The detection circuit comprises a detector 114 and a signal processor 113. Control unit 100 is connected to the sensor head 109 by means of PM connecting fiber 102.

Key element of the configuration is the 45° Faraday rotator 101 at the beginning of the sensor head and connected to connecting PM fiber 102. It results in a non-reciprocal rotation of the two forward travelling polarization states of 45° and a full roundtrip rotation of 90°. The forward propagating light polarized along the fast (slow) fiber axis is thus polarized along the slow (fast) axis when returning to the control unit. This ensures that the differential roundtrip group delays attained in the connecting fiber is zero and that phase shifts - caused e.g. by mechanical perturbations or temperature variations - cancel and do not disturb the measurement. Further details on the interrogation technique can be found in [14, 17, 24].

The device advantageously comprises at least one first and at least one second polarization maintaining fiber section 103, 104 arranged optically in series and connected to guide the light between two passes through Faraday rotator 100. The main axes of the first and second polarization maintaining fibers are mutually rotated by 90°.

The PM fiber section 103 after the 45° rotator is oriented at 45° to the connecting PM fiber 102 such that the polarizations are again aligned along the slow and fast axis of the fiber. The PM fiber in the sensing head 109 is divided into the two sections 103, 104 of equal length which are connected by a 90° splice 110. The second section 104 serves to balance the differential modal group delay and temperature-induced phase changes in the first section 103. More generally, if different types of PM fiber are used in the sensing section, their lengths and orientations are chosen such that the differential optical path length

$$\Delta L_g = \sum_i \Delta L_{g,i} = \sum_i \left( n_{g,i}^s - n_{g,i}^f \right) l_i \qquad (9)$$

is essentially zero or corresponds to a value much smaller than the coherence length of the low-coherence source. In equation (9), the $n_{g,i}$ denote the group index ($n_g = c/v_g$) for the fast (f) and slow (s) axis of the fiber in the corresponding fiber section with length li. The end of the last fiber section in the chain has a reflective coating or a mirror attached such that the light returns to the control unit.

Note: In the special case of PM fibers where the group birefringence ($n_g^s$ - $n_g^f$) and thus $\Delta L_g$ is zero at the wavelength of operation one fiber section 103, 104 is sufficient, i. e. a 90° splice is not needed.

A single pass Faraday rotation of 45° (i.e. a roundtrip rotation of 90°) at rotator 101 results in maximum interference fringe contrast (modulation depth)and thus in the highest signal-to-noise ratio. Deviations from 45° reduce the modulation depth and signal-to-noise ratio. The modulation depth becomes zero at rotations of 0°, 90°.

The sensor head further incorporates at least one optical field sensor 6 (see Fig. 11), advantageously an electro-optic crystal waveguide 34. If a differential optical path length is caused by this field sensor, it can be taken into account by appropriately adjusting the fiber lengths according to equation (9) such that the overall delay is again zero. Ideally, optical field sensors with a waveguide structure are used in this configuration to avoid the more complex collimating optics needed for the free space configurations described above. The axes of the PM fiber pigtails are oriented parallel to the electro-optic axes.

The light from sensor 6 is fed through a PM fiber 111 to a reflective coating or mirror 112.

In Fig. 12, a configuration is shown where the PM fiber sections 103, 104 at the input and the output of the electro-optic crystal are rotated by 90° with respect to each other. The 90° splice is therefore incorporated in the connection of the fibers to the optical sensor 6 or crystal 27, and an external 90° splice is not necessary.

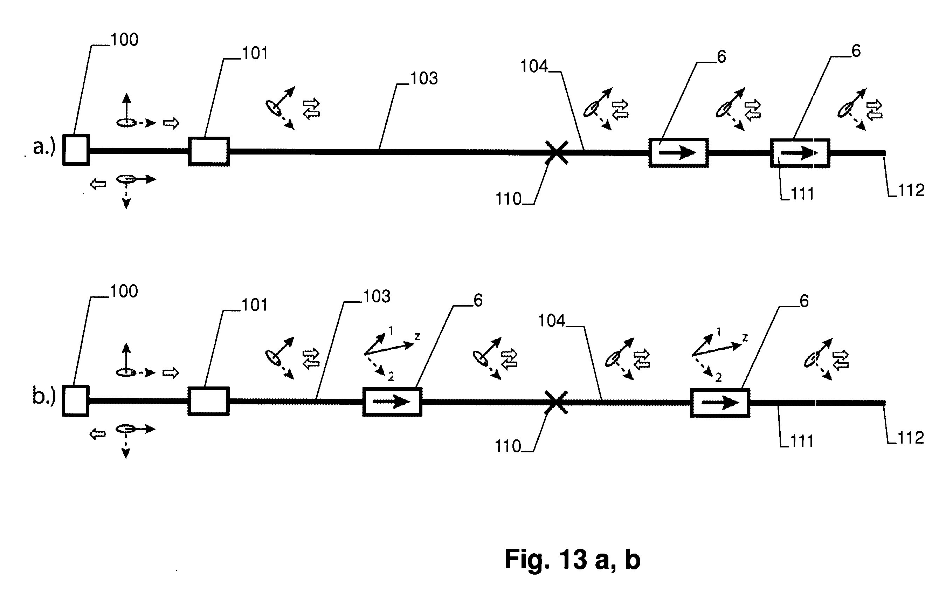

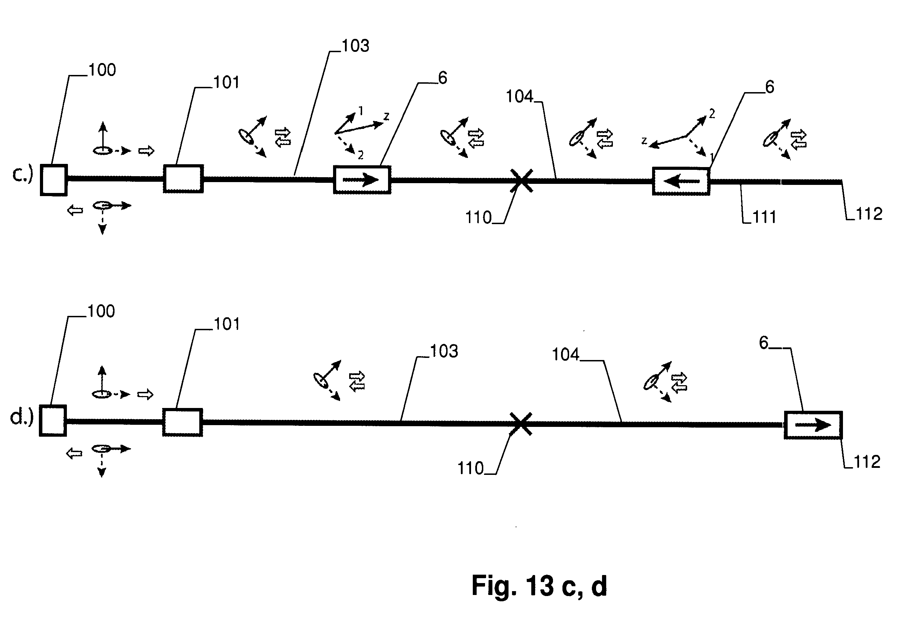

Fig. 13 shows various configurations with multiple optical field sensors 6 which can e.g. be placed at different locations within measurement cavity 7, or in different measurement cavities arranged in series in the same or in different insulators. In Fig. 13a, the electro-optic crystals 6 are positioned in the same PM fiber section 104 and have the same orientation of the electro-optic axis with respect to the fiber axes. The total field-induced differential phase shift then corresponds to the sum of the electric field strengths at the two crystals.

In Fig. 13b, the crystals 6 are positioned in two different PM fiber sections 103, 104. The crystal orientations in the two sections 103, 104 with respect to the fiber axes differ by 90°, i.e. the electro-optic axis of the crystals oriented along the fast axis of the PM fiber in the first section are oriented along the slow axis of the PM fiber in the second section in order to sum up the field strengths at the two crystals. This is depicted in more detail by the ellipses indicating the axes orientation of the PM fibers and the small numbers indicating the directions of the electro-optic axes of the crystal. For example, the polarization mode indicated by the dashed arrow is oriented along the slow axis in the first PM fiber segment and along the fast axis in the second. In both segments however the mode is polarized along axis 2 of the electro-optic crystal.

Alternatively, the PM fibers can be attached to the crystals with the same relative orientation in both sections 103, 104, provided that the crystal in the second segment is oriented anti-parallel to that in the first segment (see Fig. 13c). In this case the polarization indicated by the dashed arrow is polarized along axis 1 of the electro-optic crystal in the first segment and along axis 2 in the second segment. Because of the anti-parallel orientation of the crystal in the second segment (depicted by the z axis) the resulting differential electro-optic phase shift between the two polarizations has the same sign in both cases.

Fig. 13d shows a similar configuration as Fig. 13a: instead of using a fiber 111 with a reflective fiber end or mirror 112 attached, the electro-optic crystal is coated on one side with a reflective coating. This configuration is also possible with the crystals in two different fiber segments (Fig. 11b and c), in which case the second crystal is attached to the end of the PM fiber in the second segment.

If a single optical field sensor has to be interrogated, one can omit the PM fibers in the sensing section and directly attach the sensing element to the 45° Faraday rotator, provided the differential phase shift introduced by the sensing element is sufficiently small (see above). The 45° Faraday rotator is then placed inside the measurement cavity together with the sensing element which has a reflective coating at the end (similar to Fig. 13d).

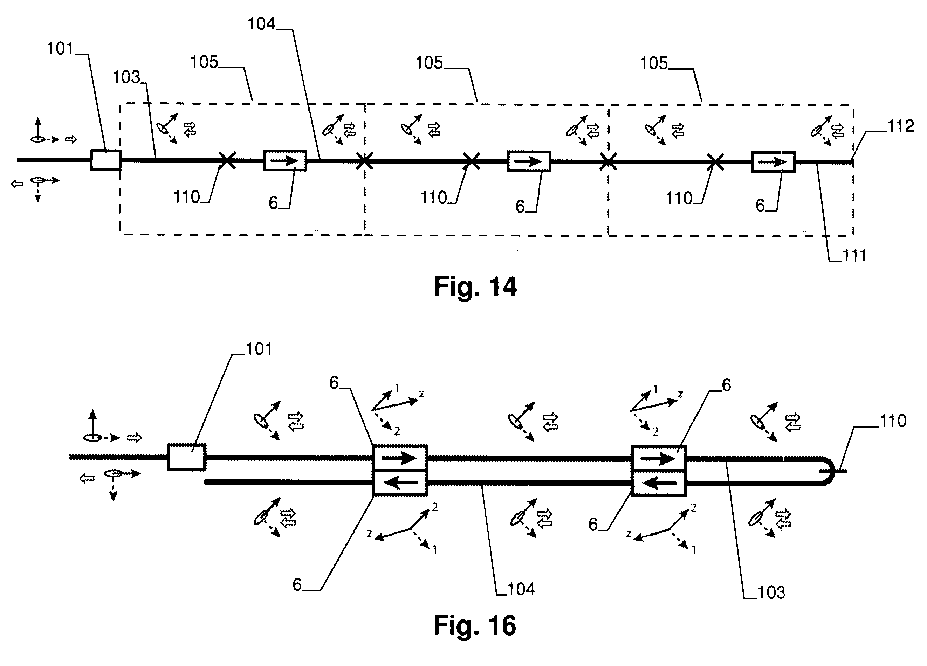

Finally, the configuration shown in Fig. 14 is particularly suitable for use with a modular insulator design. Each of the advantageously identical sensing modules 105 contains one or multiple electro-optic crystals 6 and PM fiber sections 103, 104 arranged in such a way that the differential optical path lengths are sufficiently compensated (as described above by equation (9)). The modules 105 can then be connected in series to form a voltage sensor consisting of an arbitrary number of individual sensors, each measuring a fraction of the total voltage. The PM fiber connection between the modules may be realized by 90° splices 110 as shown in Fig. 14. Alternatively, PM fiber connectors can be used with the fibers oriented at 90° with respect to each other.

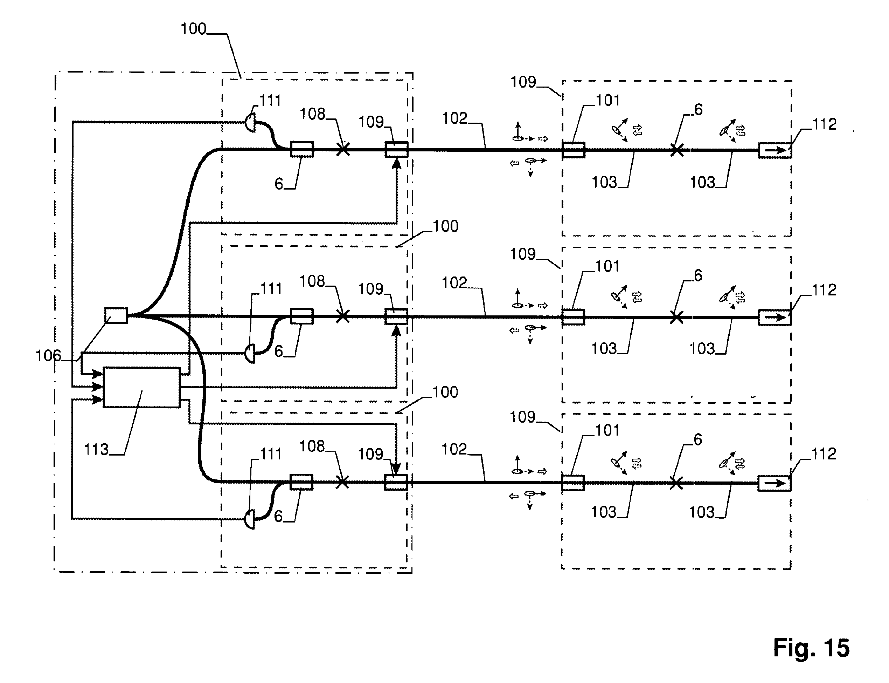

Fig. 15 shows a parallel arrangement of three identical modules having a common light source 106. This arrangement is of particular interest when measuring the voltages of three electric phases, e.g. in a high-voltage substation. A common light source 106 and signal processor may be used for all three parallel channels. Each channel can again feature a series of several modules.

Fig. 16 shows a sensor arrangement with compensation of optical phase shifts introduced by mechanical perturbations of the two fiber sections after the Faraday rotator 101. The two fiber sections 103, 104 run along the same path such that they see the same mechanical perturbations. The mechanically-induced differential phase shifts in the two segments are then essentially of the same magnitude, but due to the 90°-splice 110 they have opposite sign and therefore tend to cancel each other. The electric field sensors on the other hand are oriented with respect to the fiber axes such that the electro-optic phase shifts have the same sign for a given field direction and thus add up.

*Notes*

The voltage sensors described above use a number of electro-optic field sensors which measure the local electric field resulting from a high voltage applied to the ends of an electric insulator. Advantageously, the electro-optic field sensors are designed such that they only measure the component of the electric field along the direct path between both ends of the insulator, i.e. along the axial direction. A specially designed hollow core insulator rod is used, featuring embedded metal foils for capacitive field steering in order to form measurement cavities and to shield the electric field geometry from outside influences. The electro-optic field sensors are advantageously placed inside these measurement cavities at specific locations showing a particularly high insensitivity to external field perturbations. The electro-optically induced phase shifts are measured using different techniques and allow determining the applied voltage from the local field measurements by appropriate calibration of the voltage sensor. A single or multiple electro-optic field sensors are placed inside a measurement cavity and a single or multiple measurement cavities are present in a single electric insulator. Moreover, multiple insulators can be arranged in series to cover a wide range of voltage levels.

As mentioned, the electrodes are advantageously metal foils embedded within insulating insulator 1 with longitudinal dimensions selected such that a voltage applied to the ends of insulator 1 homogeneously drops over the length of the field sensor inside the sensing cavity 7 and over the full length of insulator 1 at its outer surface. Excessive peak electric fields are avoided.

In general terms and in an advantageous embodiment, the voltage sensor comprises an insulator 1 with mutually insulated electrodes $Ei_j$, $E_s$ embedded therein. The electrodes are coaxial and cylindrical and overlap axially over part of their lengths. They are mutually staggered and guide the homogeneous field outside the sensor to a substantially homogeneous but higher field within the sensing cavity 7 within the insulator 1. A field sensor 6 is arranged within the sensing cavity 7 to measure the field. This design allows to produce compact voltage sensors for high voltage applications.

In a advantageous configuration as shown in Fig. 1, a single measurement cavity 7 is positioned at half the distance between the ends of the insulator. Alternatively, the measurement cavity can be positioned closer to one end of the insulator. This can reduce field inhomogeneities caused by external stray capacitances and asymmetric boundary conditions such as in the three cases shown in Fig. 3 where the sensor is located above a grounded plate and its upper end is attached to a high voltage line.

In an alternative configuration, multiple measurement cavities 7 can be positioned along the axis of a single insulator and electrically connected in series to form a configuration similar to that of multiple serially connected insulators with a single measurement cavity.

Besides using sensing elements based on the Pockels effect as local electric field sensors, one can also place other types of sensing elements inside the measurement cavities. Examples are sensing elements based on the piezoelectric effect [6], on poled fibers [25-27], and miniature electro-optic devices on the tip of an optical fiber as described e.g. in [28]. The latter have been developed to map for example electric fields on integrated circuits.

Particularly with the arrangements of Fig. 8 - 16, residual temperature-induced phase shifts cannot be distinguished from electro-optic phase shifts caused by a dc or a slowly varying electric field. The configurations are therefore advantageously used to measure ac fields or fields that vary in time significantly faster than other sources affecting the differential phase of the orthogonal polarizations.

As shown in Fig. 3, the electric field extends slightly beyond the limits of the measurement cavity. Placing the sensing element in this location is also possible and has the advantage of the sensing element being subject to lower field strengths.

An additional configuration with polarimetric detection uses multiple local field sensors connected by PM fiber links such that the electro-optic phase shifts of the individual sensors are accumulated. In this configuration, only the first sensor in the series is equipped with a polarizer at its input, and only the last sensor is equipped with a polarization analyzer at its output. The fast and slow axes of the fiber links between the sensors are parallel to the electro-optic axes. The differential optical path lengths are again balanced. Residual unbalanced thermal phase shifts of the orthogonal modes may result in an undefined and varying working point, which may require an appropriate signal processing technique [30]. At electro-optic phase modulations larger than $\pm\pi/2$, the procedure of [2, 3] may again be applied.

The above mentioned integrated-optic electric field sensors use the electro-optic phase shift of the two orthogonal polarizations of the fundamental spatial waveguide mode. Another conceivable alternative is to fabricate the waveguide with parameters such that it supports besides the fundamental mode one higher-order spatial mode, as known from dual-mode fibers [29], and measure the electro-optic phase shift between the fundamental mode and higher-order mode. Advantageously, the waveguide is fabricated with elliptical shape in order to remove the degeneracy of the of the higher-order mode. Preferably the light is polarized with the polarization parallel to the major or minor core axis. By aligning the input fiber pigtail of the waveguide with an appropriate offset the two spatial modes can be excited with about equal amplitudes. Similarly the output pigtail is also aligned with an offset in order to access one lobe of the double-lobed interference pattern [29].

Apart from the interrogation techniques mentioned above, alternative methods may be used to measure the electro-optic phase shifts including techniques based on white light interferometry [31, 32].

The polarization maintaining fibers mentioned above may be e.g. so-called Panda fibers, bow-tie fibers, elliptical-core fibers, elliptical cladding fibers, or any other type of fiber with polarization maintaining properties.

<u>References</u>

1. P. A. Williams, et al., "Optical, thermooptic, electro-optic, and photoelastic properties of bismuth germanate (Bi4Ge3O12)," Appl. Opt. 35, 3562 (1996).
2. US 4, 904, 931
3. US 5, 715, 058
4. US 5,001,419
5. EP 0 316 635 B1
6. EP 0 316 619 B1
7. US 6, 140, 810
8. US 6,252,388 B1
9. US 6,380,725 B1
10. US 6,876,188 B2
11. WO 2004/086064 A1
12. US 5,029,273 A
13. G. A. Massey, et al., "Electromagnetic field components: their measurement using linear electrooptic and magnetooptic effects," Appl. Opt. 14, 2712 (1975).
14. H. Lefèvre, The fiber-optic gyroscope. London, Boston: Artech House, 1993.
15. G. Frosio and R. Dändliker, "Reciprocal reflection interferometer for a fiber-optic Faraday current sensor," Appl. Opt. 33, 6111 (1994).
16. S. Wildermuth, et al., "Interrogation of a Birefringent Fiber Sensor by Nonreciprocal Phase Modulation," IEEE Photon. Technol. Lett. 22, 1388 (2010).
17. WO 2008/077255 A1
18. US 3,875,327
19. US 4,362,897
20. WO 2007/121592 A1
21. M. Lawrence, "Lithium niobate integrated optics," Rep. Prog. Phys. 56, 363 (1993).
22. T.-H. Lee, et al., "Electromagnetic field sensor using Mach-Zehnder waveguide modulator," Microw. Opt. Techn. Lett. 48, 1897 (2006).
23. T. Meyer, et al., "Reversibility of photoinduced birefringence in ultralow-birefringence fibers," Opt. Lett. 21, 1661 (1996).
24. EP 1 154 278 B1
25. US 5,936,395
26. US 6,348,786 B1
27. WO 2009/138120 A1
28. US 2010/0283451 A1
29. US 5, 339, 026
30. J. Cole, et al., "Synthetic-heterodyne interferometric demodulation," IEEE J. Quantum Elect. 18, 694 (1982).
31. W. Urbanczyk, et al., "Digital Demodulation System for Low-Coherence Interferometric Sensors Based on Highly Birefringent Fibers," Appl. Opt. 40, 6618(2001).
32. M. Campbell, et al., "A frequency-modulated continuous wave birefringent fibre-optic strain sensor based on a Sagnac ring configuration," Meas. Sci. Technol. 10, 218 (1999).

Reference numbers

[0120]

| | |
|---|---|
| 1: | insulator |
| 2, 3: | contact points |
| 4: | metal contacts |
| 5: | bore |
| 6: | field sensor |
| 7: | sensing cavity |
| 8: | longitudinal axis |
| 10, 11: | first and second region |
| 14: | central end of electrode |
| 15: | contact end of electrode |
| 16: | reference plane |
| 20, 21: | PM delivery fibers |
| 22: | detection unit |

| 23: | polarizing beam splitter |
|---|---|
| 24: | quarter wave plate |
| 25: | dielectric substrate |
| 26: | collimating lens |
| 27: | crystal |
| 28, 29, 29': | polarizers |
| 30: | focusing lens |
| 31: | non-polarizing beam splitter element |
| 32, 32': | channels |
| 33, 33': | detectors |
| 34: | waveguide |
| 35: | polarizing layer |
| 100: | control unit |
| 101: | Faraday rotator |
| 102: | connecting PM fiber |
| 103: | first PM fiber section |
| 104: | second PM fiber section |
| 105: | sensing module |
| 106: | light source |
| 107: | inline fiber polarizer |
| 108: | 45° splice |
| 109: | sensor head |
| 110: | 90° splice |
| 111: | PM fiber |
| 112: | reflective coating or mirror |
| 113: | signal processor |
| 114: | detector |

## Claims

1. A high-voltage sensor for measuring a voltage between a first and a second contact point (2, 3) comprising an insulator (1) of an insulating material extending along an axial direction between the first and the second contact points (2, 3),

   a plurality of conductive electrodes ($Ei_j$, Es) arranged in said insulator (1), wherein said electrodes ($Ei_j$, Es) are mutually separated by said insulating material and capacitively coupled to each other,

   at least one electric field sensor (6) arranged in a sensing cavity (7) of said insulator (1),

   wherein, for at least part of said electrodes ($Ei_j$, Es), each electrode axially overlaps at least another one of said electrodes ($Ei_j$, Es),

   wherein said electrodes ($Ei_j$, Es) are arranged for generating an electric field in said sensing cavity (7) having a mean field strength larger than said voltage divided by a distance between said first and said second contact point (2, 3),

   wherein the at least one electric field sensor (6) is a local electric field sensor that measures said field over only part of an axial extension of the sensing cavity, **characterized in that** the high-voltage sensor comprises at least a first primary electrode ($E1_1$) electrically connected to the first contact point (2) and a second primary electrode ($E2_1$) electrically connected to the second contact point (3) and wherein said electrodes ($Ei_j$, $E_s$) form a capacitive voltage divider between the first and the second primary electrodes ($E1_1$, $E2_1$).

2. The high-voltage sensor of claim 1, wherein said at least one field sensor (6) is at least one optical sensor introducing a field-dependent phase shift $\Delta\varphi$ between a first sensor polarization or sensor mode and a second sensor polarization or sensor mode of light passing through it, and in particular wherein said optical sensor comprises

   an electro-optical device with field-dependent birefringence, in particular a crystal, in particular of crystalline $Bi_4Ge_3O_{12}$ (BGO) or $Bi_4Si_3O_{12}$ (BSO), or a poled waveguide exhibiting a Pockels effect, or

   a piezo-electric device, in particular of crystalline quartz or a piezoelectric ceramic, and a waveguide carrying at least two modes, wherein said waveguide is connected to said piezo-electric device thus that a length of said waveguide is field-dependent.

3. The high-voltage sensor of claim 2, comprising a plurality of said optical sensors arranged optically in series.

4. The high-voltage sensor of any of the claims 2 to 3, further comprising
a control unit (100) adapted to determine said voltage from a phase shift between light passing said optical sensor in said first sensor polarization or sensor mode and light passing said optical sensor in said second sensor polarization or sensor mode,
a Faraday rotator (101) arranged between said control unit (100) and said optical sensor, wherein said Faraday rotator (101) results in a nonreciprocal rotation of said light by 45° for each pass.

5. The high-voltage sensor of claim 4, further comprising at least one first and at least one second polarization maintaining fiber section (103, 104) arranged optically in series and connected to guide said light between two passes through said Faraday rotator (101), wherein main axes of said first and second polarization maintaining fibers sections (103, 104) are mutually rotated by 90°, and in particular wherein a total differential group delay $\Delta L_g$ of the polarization maintaining fiber sections (103, 104) is much smaller than a coherence length of the light source, and in particular the high-voltage sensor comprising a plurality of sensing modules (105) arranged optically in series, wherein each sensing module (105) comprises at least one of said first and at least one of said second polarization maintaining fiber sections (103, 104) and at least one optical sensor (6).

6. The high-voltage sensor of any of the claims 2 to 3, comprising
a polarization maintaining fiber (21) having at least a first polarization mode, wherein said polarization maintaining fiber (21) is connected to said optical sensor in such a manner that

- light passing said optical sensor in said first sensor polarization or sensor mode as well as
- light passing said optical sensor in said second sensor polarization or sensor mode are both partially coupled into said first polarization mode of said polarization maintaining fiber (21),

a detector unit (22) connected to said polarization maintaining fiber (21), said detector unit (22) comprising at least a first light detector measuring light passing through said first polarization mode of said polarization maintaining fiber (21).

7. The high-voltage sensor of any of the claims 2 to 6, wherein a temperature derivative of an electro-optic effect of said field sensor has opposite sign to a temperature derivative $\partial|E_{z,mean}|\partial T$ of a mean absolute value of an axial electrical field component in said optical sensor.

8. The high-voltage sensor of any of the claims 2 to 7, wherein said optical sensor comprises a waveguide, and/or wherein said optical sensor is of a III-V-semiconductor, in particular GaAs.

9. The high-voltage sensor of any of the preceding claims, wherein said cavity (7) is symmetrical to a reference plane (16) extending perpendicularly to said axial direction, wherein a position of said at least one field sensor (6) is symmetrical to said reference plane and/or wherein a plurality of said field sensors (6, 6') is arranged symmetrically in respect to said reference plane (16).

10. An assembly of several high-voltage sensors of any of the preceding claims, in particular several of said high-voltage sensors being arranged in series and/or in parallel, and further in particular the assembly comprising a common light source and/or signal processor for said high-voltage sensors.

11. The high-voltage sensor of any of the preceding claims wherein at least one of said electrodes (Ei_j, Es) is a shield electrode (E_s) radially surrounding said sensing cavity (7).

12. The high-voltage sensor of any of the preceding claims wherein said electrodes (Ei_j, E_s) comprise a first set of electrodes E1_i with i = 1 .. N1 and a second set of electrodes E2_i with i = 1 .. N2, with the electrodes E1_i of the first set being arranged in a first region (10) of said insulator (1), which first region (10) extends from a reference plane (16) of said sensing cavity (7) to said first contact point (2), and with the electrodes E2_i of the second set being arranged in a second region (11) of said insulator (1), which second region (11) extends from said reference plane (16) to said second contact point (3), wherein said reference plane (16) extends radially through said sensing cavity (7), in particular N1 = N2, and
in particular wherein a first electrode E1_1 of said first set forms said first primary electrode and a first electrode E2_1 of said second set forms said second primary electrodes, and
further in particular wherein, for each set j of electrodes, the electrodes Ej_i and Ej_{i+1} axially overlap along an overlapping section, wherein, in said overlapping section, the electrode Ej_{i+1} is arranged radially outside from the electrode

$Ej_i$.

13. The high-voltage sensor of claim 12, wherein, for each set j of electrodes,
   each electrode has a central end (14) facing said reference plane (16) and a contact end (15) axially opposite to said center (14) end,
   the center end (14) of the electrode $Ej_{i+1}$ is closer to said reference plane (16) than the center end (14) of the electrode $Ej_i$, and the contact end (15) of the electrode $Ej_{i+1}$ is closer said reference plane (16) than the contact end (15) of the electrode $Ej_i$,
   the center end (14) of the electrode $Ej_{i+1}$ has an axial distance $Bj_i$ from the center end (15) of the electrode $Ej_i$, and
   the contact end (14) of the electrode $Ej_{i+1}$ has an axial distance $Cj_i$ from the contact end (14) of the electrode $Ej_i$, and
   the electrodes $Ej_i$ and $Ej_{i+1}$ axially overlap between the contact end (15) of the electrode $Ej_{i+1}$ and the center end (14) of the electrode $Ej_i$, and
   in particular wherein, for each set j of electrodes, the axial distance $Bj_i$ is smaller than the axial distance $Cj_i$, and further in particular wherein, for each set j of electrodes, the axial distances $Bj_i$ are substantially
   equal to a common distance B and/or the axial distances $Cj_i$ are substantially equal to a common distance C.

14. The high-voltage sensor of any of the claims 12 to 13 and of claim 11, wherein said shield electrode ($E_S$) axially overlaps with at least one electrode of said first set and at least one electrode of said second set,
   and in particular wherein the shield electrode ($E_S$) axially overlaps with an radially outmost electrode ($E1_6$) of said first set and a radially outmost electrode ($E2_6$) of said second set and is arranged radially outside from said outmost electrodes ($E1_6$, $E2_6$) of said first and said second sets.

15. The high-voltage sensor of any of the claims 12 to 14, wherein the electrodes $E1_i$ of said first set are equally spaced in radial direction and wherein the electrodes $E2_i$ of said second set are equally spaced in radial direction,
   and/or wherein said electrodes are arranged symmetrically in respect to a reference plane (16) extending radially through said sensing cavity (7),
   and/or wherein at least part, in particular all, of said electrodes ($Ej_i$, $E_S$) are substantially cylindrical and/or coaxial to each other.

16. The high-voltage sensor of any of the preceding claims, further comprising a dielectric substrate (25) arranged in said cavity (7) and holding said field sensor (6), and in particular wherein said substrate (25) has the shape of a beam extending axially through said cavity (7).

17. The high-voltage sensor of any of the preceding claims, wherein the cavity has an axial length d, which is the axial distance between a center end (14)
   of the first primary electrode ($E1_1$) of the first set of electrodes and a center end of the second primary electrode ($E2_1$) of the second set of electrodes, and an axial length $l$ of the field sensor is smaller, in particular at least 5 times smaller, than the axial length d of the cavity.

**Patentansprüche**

1. Hochspannungssensor zum Messen einer Spannung zwischen einem ersten und einem zweiten Anschlusspunkt (2, 3), der Folgendes aufweist:

   einen Isolator (1) aus einem Isoliermaterial, der sich entlang einer Achsenrichtung zwischen dem ersten und dem zweiten Anschlusspunkt (2, 3) erstreckt,
   mehrere leitfähige Elektroden ($Ei_j$, Es), die in dem Isolator (1) angeordnet sind, wobei die Elektroden ($Ei_j$, Es) gegenseitig durch das Isoliermaterial getrennt und kapazitiv aneinander gekoppelt sind,
   mindestens einen elektrischen Feldsensor (6), der in einer Messkavität (7) des Isolators (1) angeordnet ist,
   wobei für mindestens einen Teil der Elektroden ($Ei_j$, Es) jede Elektrode mindestens eine andere der Elektroden ($Ei_j$, Es) axial überlappt,
   wobei die Elektroden ($Ei_j$, Es) angeordnet sind, um ein elektrisches Feld in der Messkavität (7) zu erzeugen, das eine mittlere Feldstärke aufweist,
   die größer ist als die Spannung geteilt durch einen Abstand zwischen dem ersten und dem zweiten Anschluss-spunkt (2, 3),
   wobei der mindestens eine elektrische Feldsensor (6) ein lokaler elektrischer Feldsensor ist, der das Feld über lediglich einen Teil der axialen Ausdehnung der Messkavität misst, **dadurch gekennzeichnet, dass** der Hochspannungssensor mindestens eine erste Primärelektrode (E1$_1$), die elektrisch mit dem ersten Anschlusspunkt (2) verbunden ist, und eine zweite Primärelektrode (E2$_1$) aufweist, die elektrisch mit dem zweiten Anschlusspunkt (3) verbunden ist, und wobei die Elektroden (Ei$_j$, E$_S$) einen kapazitiven Spannungsteiler zwischen der ersten und der zweiten Primärelektrode (E1$_1$, E2$_1$) bilden.

2. Hochspannungssensor nach Anspruch 1, wobei der mindestens eine Feldsensor (6) mindestens ein optischer Sensor ist, der eine feldabhängige Phasenverschiebung $\Delta\varphi$ zwischen einer ersten Sensorpolarisation oder Sensormode und einer zweiten Sensorpolarisation oder Sensormode von Licht, das ihn durchquert, einführt, und der optische Sensor insbesondere Folgendes aufweist:

   eine elektrooptische Vorrichtung mit feldabhängiger Doppelbrechung, insbesondere einen Kristall, insbesondere aus kristallinem Bi$_4$Ge$_3$O$_{12}$ (BGO) oder Bi$_4$Si$_3$O$_{12}$ (BSO), oder einen gepolten Wellenleiter, der einen Pockels-Effekt aufweist,
   oder
   eine piezoelektrische Vorrichtung, insbesondere aus kristallinem Quarz oder einer piezoelektrischen Keramik, und einen Wellenleiter, der mindestens zwei Moden trägt, wobei der Wellenleiter derart mit der piezoelektrischen Vorrichtung verbunden ist, dass eine Länge des Wellenleiters feldabhängig ist.

3. Hochspannungssensor nach Anspruch 2, der mehrere von den optischen Sensoren aufweist, die optisch in Reihe angeordnet sind.

4. Hochspannungssensor nach einem der Ansprüche 2 bis 3, der ferner Folgendes aufweist:

   eine Steuereinheit (100), die angepasst ist, um die Spannung von einer Phasenverschiebung zwischen Licht, das den optischen Sensor in der ersten Sensorpolarisation oder Sensormode durchquert und
   Licht, das den optischen Sensor in der zweiten Sensorpolarisation oder Sensormode durchquert, zu bestimmen
   einen Faraday-Rotator (101), der zwischen der Steuereinheit (100) und dem optischen Sensor angeordnet ist, wobei der Faraday-Rotator (101) eine nicht reziproke Drehung des Lichts um 45° für jede Durchquerung ergibt.

5. Hochspannungssensor nach Anspruch 4, der ferner mindestens einen ersten und mindestens einen zweiten Faserabschnitt (103, 104) zum Aufrechterhalten der Polarisation aufweist, die optisch in Reihe angeordnet und verbunden sind, um das Licht zwischen zwei Durchquerungen durch den Faraday-Rotator (101) zu leiten, wobei die Hauptachsen des ersten und zweiten Faserabschnitts (103, 104) zum Aufrechterhalten der Polarisation gegenseitig um 90° gedreht sind, und wobei insbesondere eine gesamte differentielle Gruppenlaufzeit $\Delta L_g$ der Faserabschnitte (103, 104) zum Aufrechterhalten der Polarisation viel kleiner ist als eine Kohärenzlänge der Lichtquelle, und der Hochspannungssensor insbesondere mehrere Abtastmodule (105) aufweist, die optisch in Reihe angeordnet sind, wobei jedes Abtastmodul (105) mindestens einen von dem ersten und mindestens einen von dem zweiten Faserabschnitt (103, 104) zum Aufrechterhalten der Polarisation und mindestens einen optischen Sensor (6) aufweist.

6. Hochspannungssensor nach einem der Ansprüche 2 bis 3, der Folgendes aufweist:

   eine polarisationserhaltende Faser (21), die mindestens eine erste Polarisationsmode aufweist,
   wobei die polarisationserhaltende Faser (21) derart mit dem optischen Sensor verbunden ist,
   dass:

   - sowohl Licht, das den optischen Sensor in der ersten Sensorpolarisation oder Sensormode durchquert, als auch
   - Licht, das den optischen Sensor in der zweiten Sensorpolarisation oder Sensormode durchquert,

   teilweise in der ersten Polarisationsmode der polarisationserhaltenden Faser (21) zum Aufrechterhalten der Polarisation gekoppelt sind,
   eine Detektoreinheit (22), die mit der polarisationserhaltenden Faser (21) verbunden ist,
   wobei die Detektoreinheit (22) mindestens einen ersten Lichtdetektor aufweist, der Licht misst,
   das die erste Polarisationsmode der polarisationserhaltenden Faser (21) durchquert.

7. Hochspannungssensor nach einem der Ansprüche 2 bis 6, wobei eine von einem elektrooptischen Effekt des Feldsensors abgeleitete Temperatur ein umgekehrtes Vorzeichen zu einer von einem mittleren Absolutwert einer axialen elektrischen Feldkomponente in dem optischen Sensor abgeleiteten Temperatur $\partial|E_z, \text{Mittelwert}|\partial T$ aufweist.

8. Hochspannungssensor nach einem der Ansprüche 2 bis 7, wobei der optische Sensor einen Wellenleiter aufweist und/oder wobei der optische Sensor aus einem III-V-Halbleiter, insbesondere GaAs, besteht.

9. Hochspannungssensor nach einem der vorhergehenden Ansprüche, wobei die Messkavität (7) symmetrisch zu einer Bezugsebene (16) ist, die sich senkrecht zur Achsenrichtung erstreckt, wobei eine Position des mindestens einen Feldsensors (6) symmetrisch zu der Bezugsebene ist und/oder wobei mehrere der Feldsensoren (6, 6') symmetrisch zur Bezugsebene (16) angeordnet sind.

10. Baugruppe aus mehreren Hochspannungssensoren nach einem der vorhergehenden Ansprüche, wobei insbesondere mehrere der Hochspannungssensoren in Reihe und/oder parallel angeordnet sind, und die Baugruppe ferner insbesondere eine/n gemeinsame/n Lichtquelle und/oder Signalprozessor für die Hochspannungssensoren aufweist.

11. Hochspannungssensor nach einem der vorhergehenden Ansprüche, wobei die mindestens eine der Elektroden ($Ei_j$, Es) eine Schirmelektrode ($E_s$) ist, die die Messkavität (7) radial umgibt.

12. Hochspannungssensor nach einem der vorhergehenden Ansprüche, wobei die Elektroden ($Ei_j$, $E_s$) eine erste Menge von Elektroden $E1_i$ mit i = 1 .. N1 und eine zweite Menge von Elektroden $E2_i$ mit i = 1 .. N2 aufweisen, wobei die Elektroden $E1_i$ der ersten Menge in einem ersten Bereich (10) des Isolators (1) angeordnet sind, wobei sich der erste Bereich (10) von einer Bezugsebene (16) der Messkavität (7) zum ersten Anschlusspunkt (2) erstreckt, und wobei die Elektroden $E2_i$ der zweiten Menge in einem zweiten Bereich (11) des Isolators (1) angeordnet sind, wobei sich der zweite Bereich (11) von der Bezugsebene (16) zum zweiten Anschlusspunkt (3) erstreckt, wobei die Bezugsebene (16) sich radial durch die Messkavität (7) erstreckt, insbesondere N1 = N2, und wobei eine erste Elektrode $El_1$ der ersten Menge insbesondere die erste Primärelektrode bildet und eine erste Elektrode $E2_1$ der zweiten Menge die zweiten Primärelektroden bildet, und wobei ferner insbesondere für jede Menge j von Elektroden die Elektroden $Ej_i$ und $Ej_{i+1}$ sich axial entlang eines Überlappungsabschnitts überlappen, wobei die Elektrode $Ej_{i+1}$ in dem Überlappungsabschnitt radial außerhalb der Elektrode $Ej_i$ angeordnet ist.

13. Hochspannungssensor nach Anspruch 12, wobei für jede Menge j von Elektroden, jede Elektrode ein mittleres Ende (14) aufweist, das der Bezugsebene (16) zugewandt ist, und ein Anschlussende (15) aufweist, das dem mittleren Ende (14) axial entgegengesetzt ist, wobei das mittlere Ende (14) der Elektrode $Ej_{i+1}$ näher an der Bezugsebene (16) liegt als das mittlere Ende (14) der Elektrode $Ej_i$ und das Anschlussende (15) der Elektrode $Ej_{i+1}$ näher an der Bezugsebene (16) liegt als das Anschlussende (15) der Elektrode $Ej_i$, wobei das mittlere Ende (14) der Elektrode $Ej_{i+1}$ einen axialen Abstand $Bj_i$ von dem mittleren Ende (15) der Elektrode $Ej_i$ aufweist und das Anschlussende (14) der Elektrode $Ej_{i+1}$ einen axialen Abstand $Cj_i$ von dem Anschlussende (14) der Elektrode $Ej_i$ aufweist, und wobei die Elektroden $Ej_i$ und $Ej_{i+1}$ sich zwischen dem Anschlussende (15) der Elektrode $Ej_{i+1}$ und dem mittleren Ende (14) der Elektrode $Ej_i$ überlappen, und wobei der axiale Abstand $Bj_i$ insbesondere für jede Menge j von Elektroden kleiner ist als der axiale Abstand $Cj_i$, und wobei die axialen Abstände $Bj_i$ insbesondere für jede Menge j von Elektroden ferner im Wesentlichen gleich einem gemeinsamen Abstand B sind und/oder die axialen Abstände $Cj_i$ im Wesentlichen gleich einem gemeinsamen Abstand C sind.

14. Hochspannungssensor nach einem der Ansprüche 12 bis 13 und nach Anspruch 11, wobei die Schirmelektrode ($E_s$) sich axial mit mindestens einer Elektrode von der ersten Menge und mindestens einer Elektrode von der zweiten Menge überlappt, und wobei die Schirmelektrode ($E_s$) sich insbesondere mit einer radial am weitesten außen gelegenen Elektrode ($E1_6$) der ersten Menge und einer radial am weitesten außen gelegenen Elektrode ($E2_6$) der zweiten Menge überlappt und radial außerhalb der am weitesten außen gelegenen Elektroden ($E1_6$, $E2_6$) der ersten und der zweiten Menge angeordnet ist.

15. Hochspannungssensor nach einem der Ansprüche 12 bis 14, wobei die Elektroden $E1_i$ der ersten Menge in der radialen Richtung gleich beabstandet sind und wobei die Elektroden $E2_i$ der zweiten Menge in der radialen Richtung gleich beabstandet sind, und/oder wobei die Elektroden symmetrisch zu einer Bezugsebene (16) angeordnet sind, die sich radial durch die Messkavität (7) erstreckt, und/oder wobei mindestens ein Teil und insbesondere alle der Elektroden ($Ej_i$, $E_s$) im Wesentlichen zylindrisch und/oder koaxial zueinander sind.

**16.** Hochspannungssensor nach einem der vorhergehenden Ansprüche, der ferner ein dielektrisches Substrat (25) aufweist, das in der Messkavität (7) angeordnet ist und den Feldsensor (6) hält, und wobei das Substrat (25) insbesondere die Form eines Trägers aufweist, der sich axial durch die Messkavität (7) erstreckt.

**17.** Hochspannungssensor nach einem der vorhergehenden Ansprüche, wobei die Messkavität eine axiale Länge d aufweist, die der axiale Abstand zwischen einem mittleren Ende (14) der ersten Primärelektrode ($E1_1$) der ersten Menge von Elektroden und einem mittleren Ende der zweiten Primärelektrode ($E2_1$) der zweiten Menge von Elektroden ist, und eine axiale Länge 1 des Feldsensors kleiner, insbesondere mindestens 5 Mal kleiner, als die axiale Länge d der Messkavität ist.

**Revendications**

**1.** Capteur à haute tension servant à mesurer la tension entre un premier et un deuxième point de contact (2, 3) et comprenant :

un isolateur (1) en matériau isolant, qui s'étend dans la direction axiale entre le premier et le deuxième point de contact (2, 3),
plusieurs électrodes conductrices ($Ei_j$, Es) agencées dans ledit isolateur (1), lesdites électrodes ($Ei_j$, Es) étant séparées mutuellement par ledit matériau isolant et couplées capacitivement les uns aux autres,
au moins un capteur (6) de champ électrique agencé dans une cavité de détection (7) dudit isolateur (1),
au moins certaines desdites électrodes ($Ei_j$, Es) recouvrant axialement au moins une autre desdites électrodes ($Ei_j$, Es),
lesdites électrodes ($Ei_j$, Es) étant agencées de manière à produire dans ladite cavité de détection (7) un champ électrique dont la force moyenne est supérieure à ladite tension divisée par la distance qui sépare ledit premier et ledit deuxième point de contact (2, 3),
le ou les capteurs (6) de champ électrique étant des capteurs de champ électrique local qui mesurent ledit champ sur seule une partie de l'extension axiale de la cavité de détection,
**caractérisé en ce que**
le capteur à haute tension comprend au moins une première électrode primaire ($E1_1$) raccordée électriquement au premier point de contact (2) et une deuxième électrode primaire ($E2_1$) raccordée électriquement au deuxième point de contact (3) et
**en ce que** lesdites électrodes ($Ei_j$, Es) forment un diviseur de tension capacitif entre la première et la deuxième électrode primaire ($E1_1$, $E2_1$).

**2.** Capteur à haute tension selon la revendication 1, dans lequel ledit ou lesdits capteurs de champ (6) sont au moins un capteur optique qui, entre un premier mode de polarisation de capteur ou mode de capteur et un deuxième mode de polarisation du capteur ou mode de capteur, établit pour la lumière qui le traverse un déphasage $\Delta\varphi$ qui dépend du champ, et dans lequel ledit capteur optique comprend en particulier un dispositif électro-optique dont la réfringence dépend du temps, en particulier un cristal, en particulier un $Bi_4Ge_3O_{12}$ cristallin (BGO), un $Bi_4Si_3O_{13}$ cristallin (BSO), un guide d'onde polarisé présentant un effet de Pockels ou un dispositif piézoélectrique, en particulier en quartz cristallin ou en céramique piézoélectrique, et un guide d'onde qui transporte au moins deux modes, ledit guide d'onde étant raccordé audit dispositif piézoélectrique de telle sorte que la longueur dudit guide d'onde dépende du champ.

**3.** Capteur à haute tension selon la revendication 2, comprenant plusieurs desdits capteurs optiques agencés optiquement en série.

**4.** Capteur à haute tension selon l'une quelconque des revendications 2 à 3, comprenant en outre une unité de commande (100) adaptée pour déterminer ladite tension à partir du déphasage entre la lumière qui traverse ledit capteur optique dans ledit premier mode de polarisation de capteur ou mode de capteur et la lumière qui traverse ledit capteur optique dans ledit deuxième mode de polarisation de capteur ou mode de capteur et un rotateur de Faraday (101) agencé entre ladite unité de commande (100) et ledit capteur optique, ledit rotateur de Faraday (101) entraînant lors de chaque passage une rotation non réciproque de 45° de ladite lumière.

**5.** Capteur à haute tension selon la revendication 4, comprenant en outre au moins une première et au moins une deuxième section de fibre (103, 104) maintenant la polarisation, agencées optiquement en série et raccordées de manière à guider ladite lumière entre deux passages à travers ledit rotateur de Faraday (101), l'axe principal de ladite première et l'axe principal de ladite deuxième section de fibre (103, 104) maintenant la polarisation étant tournés l'un par rapport à l'autre de 90°, et en particulier dans lequel le retard différentiel total de groupe $\Delta L_g$ des sections de fibre (103, 104) maintenant la polarisation est beaucoup plus petit que la longueur de cohérence de la source de lumière, le capteur à haute tension comprenant en particulier plusieurs modules de détection (105) agencés optiquement en série, chaque module de détection (105) comprenant au moins l'une desdites premières et au moins l'une desdites deuxièmes sections de fibre (103, 104) maintenant la polarisation et au moins un capteur optique (6).

6. Capteur à haute tension selon l'une quelconque des revendications 2 à 3, comprenant
une fibre (21) maintenant la polarisation et présentant au moins un premier mode de polarisation, ladite fibre (21) maintenant la polarisation étant raccordée audit capteur optique de telle sorte que la lumière qui traverse ledit capteur optique dans ledit premier mode de polarisation de capteur ou mode de capteur ainsi que la lumière traversant ledit capteur optique dans ledit deuxième mode de polarisation de capteur ou mode de capteur soient toutes partiellement injectées dans ledit premier mode de polarisation de ladite fibre (21) maintenant la polarisation,
une unité de détection (22) raccordée à ladite fibre (21) maintenant la polarisation, ladite unité de détection (22) comprenant au moins un premier détecteur de lumière qui mesure la lumière qui traverse ledit premier mode de polarisation de ladite fibre (21) maintenant la polarisation.

7. Capteur à haute tension selon l'une quelconque des revendications 2 à 6, dans lequel le signe de la dérivée en fonction de la température d'un effet électro-optique dudit capteur de champ l'opposé du signe de la dérivée en fonction de la température $\delta|E_z$, moyen$|/\delta T$ de la valeur absolue moyenne de la composante axiale du champ électrique dans ledit capteur optique.

8. Capteur à haute tension selon l'une quelconque des revendications 2 à 7, dans lequel ledit capteur optique comprend un guide d'onde et/ou dans lequel ledit capteur optique est constitué d'un semi-conducteur III-V, en particulier le GaAs.

9. Capteur à haute tension selon l'une quelconque des revendications précédentes, dans lequel ladite cavité (7) est symétrique par rapport à un plan de référence (16) qui s'étend perpendiculairement à ladite direction axiale, la position dudit ou desdits capteurs de champ (6) étant symétrique par rapport audit plan de référence, et/ou dans lequel plusieurs desdits capteurs de champ (6, 6') sont agencés symétriquement par rapport audit plan de référence (16).

10. Ensemble constitué de plusieurs capteurs à haute tension selon l'une quelconque des revendications précédentes, en particulier de plusieurs desdits capteurs à haute tension agencés en série et/ou en parallèle, l'ensemble comprenant en outre et en particulier une source commune de lumière et/ou un processeur commun de signaux pour lesdits capteurs à haute tension.

11. Capteur à haute tension selon l'une quelconque des revendications précédentes, dans lequel au moins l'une desdites électrodes (Ei$_j$, E$_s$) est une électrode de blindage (E$_s$) qui entoure radialement ladite cavité de détection (7).

12. Capteur à haute tension selon l'une quelconque des revendications précédentes, dans lequel lesdites électrodes (Ei$_j$, E$_s$) comprennent un premier jeu d'électrodes E1$_i$ = 1 ... N1 et un deuxième jeu d'électrodes E2$_i$, = 1 ... N2, les électrodes E1$_i$ du premier jeu étant agencées dans une première partie (10) dudit isolateur (1), cette première partie (10) s'étendant depuis un plan de référence (16) de ladite cavité de détection (7) jusqu'audit premier point de contact (2), les électrodes E2$_i$ du deuxième jeu étant agencées dans une deuxième partie (11) dudit isolateur (1), cette deuxième partie (11) s'étendant depuis ledit plan de référence (16) jusqu'audit deuxième point de contact (3), ledit plan de référence (16) s'étendant radialement à travers ladite cavité de détection (7), avec en particulier N1 = N2 et dans lequel en particulier une première électrode E1$_1$ dudit premier ensemble forme ladite première électrode primaire et une première électrode E2$_1$ dudit deuxième ensemble forme ladite deuxième électrode primaire et dans lequel, en particulier pour chaque jeu j d'électrodes, les électrodes Ej$_i$ et Ej$_{i+1}$ se superposent en outre axialement sur une partie de superposition, l'électrode Ej$_{i+1}$ étant agencée radialement à l'extérieur de l'électrode Ej$_i$ dans ladite partie de superposition.

13. Capteur à haute tension selon la revendication 12, dans lequel pour chaque jeu j d'électrodes, chaque électrode présente une extrémité centrale (14) située face audit plan de référence (16) et une extrémité de contact (15) située axialement à l'opposé de ladite extrémité centrale (14), l'extrémité centrale (14) de l'électrode $Ej_{i+1}$ étant plus proche dudit plan de référence (16) que l'extrémité centrale (14) de l'électrode $Eji$ et l'extrémité de contact (15) de l'électrode $Ej_{i+1}$ étant plus proche dudit plan de référence (16) que l'extrémité de contact (15) de l'électrode $(Ej_i)$, l'extrémité centrale (14) de l'électrode $Ej_{i+1}$ présentant une distance axiale $Bj_i$ par rapport à l'extrémité centrale (15) de l'électrode $Ej_i$ et l'extrémité de contact (14) de l'électrode $Ej_{i+1}$ présentant une distance axiale $Cj_i$ par rapport à l'extrémité de contact (14) de l'électrode $Ej_i$, les électrodes $Ej_i$ et $Ej_{i+1}$ étant superposées axialement entre l'extrémité de contact (15) de l'électrode $Ej_{i+1}$ et l'extrémité centrale (14) de l'électrode $Ej_i$, pour chaque jeu j d'électrodes, la distance axiale $Bj_i$ étant en particulier plus petite que la distance axiale $Cj_i$ et en outre, en particulier pour chaque jeu j d'électrodes, les distances axiales $Bj_i$ étant essentiellement égales à une distance commune B et/ou les distances axiales $Cj_i$ étant essentiellement égales à une distance commune C.

**14.** Capteur à haute tension selon l'une quelconque des revendications 12 à 13 et selon la revendication 11, dans lequel ladite électrode de blindage $(E_s)$ se superpose axialement à au moins une électrode dudit premier jeu et à au moins une électrode dudit deuxième jeu et en particulier dans lequel l'électrode de blindage $E_s$ se superpose axialement à l'électrode $(E1_6)$ la plus extérieure radialement dudit premier jeu et l'électrode $(E2_6)$ située radialement le plus à l'extérieur dudit deuxième jeu est agencée radialement à l'extérieur desdites électrodes extérieures $(E1_6, E2_6)$ dudit premier et dudit deuxième jeu.

**15.** Capteur à haute tension selon l'une quelconque des revendications 12 à 14, dans lequel les électrodes $E1_i$ dudit premier jeu sont espacées de manière égale dans la direction radiale et dans lequel les électrodes $E2_i$ dudit deuxième jeu sont espacées de manière égale dans la direction radiale, dans lequel lesdites électrodes sont agencées symétriquement par rapport à un plan de référence (16) qui s'étend radialement dans ladite cavité de détection (7) et/ou dans lequel au moins certaines et en particulier toutes lesdites électrodes $(Ej_i, E_s)$ sont essentiellement cylindriques et/ou coaxiales les unes par rapport aux autres.

**16.** Capteur à haute tension selon l'une quelconque des revendications précédentes, comprenant en outre un substrat diélectrique (25) agencé dans ladite cavité (7) et maintenant ledit capteur de champ (6), ledit substrat (25) présentant en particulier la forme d'une poutre qui s'étend axialement dans ladite cavité (7).

**17.** Capteur à haute tension selon l'une quelconque des revendications précédentes, dans lequel la cavité présente une longueur axiale d qui est la distance axiale entre l'extrémité centrale (14) de la première électrode primaire $(E1_1)$ du premier jeu d'électrodes et l'extrémité centrale de la deuxième électrode primaire $(E2_1)$ du deuxième jeu d'électrodes, la longueur axiale 1 du capteur de champ étant plus petite et en particulier au moins 5 fois plus petite que la longueur axiale d de la cavité.

Fig. 1

Fig. 2

measurement cavity (length $L_{cav}$)

compressible filler

equipotential lines

epoxy

**Fig. 3**

**Fig. 4**

**Fig. 5**

**Fig. 6**

**Fig. 7**

**Fig. 8**

**Fig. 9**

a               b         **Fig. 10**

EP 2 577 327 B1

EP 2 577 327 B1

**Fig. 11**

**Fig. 12**

**Fig. 13 a, b**

Fig. 13 c, d

**Fig. 14**

**Fig. 16**

EP 2 577 327 B1

Fig. 15

Fig. 17

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 4904931 A
- US 5715058 A
- EP 0316635 A
- EP 0316619 A
- US 6140810 A
- US 6252388 B
- US 6380725 B
- US 5029273 A
- CH 547496 A
- EP 2138853 A1
- US 3462545 A
- US 5001419 B
- EP 0316635 B1
- EP 0316619 B1

- US 6252388 B1
- US 6380725 B1
- US 6876188 B2
- WO 2004086064 A1
- WO 2008077255 A1
- US 3875327 A
- US 4362897 A
- WO 2007121592 A1
- EP 1154278 B1
- US 5936395 A
- US 6348786 B1
- WO 2009138120 A1
- US 20100283451 A1
- US 5339026 A

### Non-patent literature cited in the description

- **P. A. WILLIAMS et al.** Optical, thermooptic, electro-optic, and photoelastic properties of bismuth germanate (Bi4Ge3O12. *Appl. Opt.,* 1996, vol. 35, 3562
- **G. A. MASSEY et al.** Electromagnetic field components: their measurement using linear electrooptic and magnetooptic effects. *Appl. Opt.,* 1975, vol. 14, 2712
- **H. LEFÈVRE.** The fiber-optic gyroscope. Artech House, 1993
- **G. FROSIO ; R. DÄNDLIKER.** Reciprocal reflection interferometer for a fiber-optic Faraday current sensor. *Appl. Opt.,* 1994, vol. 33, 6111
- **S. WILDERMUTH et al.** Interrogation of a Birefringent Fiber Sensor by Nonreciprocal Phase Modulation. *IEEE Photon. Technol. Lett.,* 2010, vol. 22, 1388
- **M. LAWRENCE.** Lithium niobate integrated optics. *Rep. Prog. Phys.,* 1993, vol. 56, 363

- **T.-H. LEE et al.** Electromagnetic field sensor using Mach-Zehnder waveguide modulator. *Microw. Opt. Techn. Lett.,* 2006, vol. 48, 1897
- **T. MEYER et al.** Reversibility of photoinduced birefringence in ultralow-birefringence fibers. *Opt. Lett.,* 1996, vol. 21, 1661
- **J. COLE et al.** Synthetic-heterodyne interferometric demodulation. *IEEE J. Quantum Elect.,* 1982, vol. 18, 694
- **W. URBANCZYK et al.** Digital Demodulation System for Low-Coherence Interferometric Sensors Based on Highly Birefringent Fibers. *Appl. Opt.,* 2001, vol. 40, 6618
- **M. CAMPBELL et al.** A frequency-modulated continuous wave birefringent fibre-optic strain sensor based on a Sagnac ring configuration. *Meas. Sci. Technol.,* 1999, vol. 10, 218